# EUROPÄISCHE PATENTSCHRIFT

(11) **EP 4 399 776 B1**
(45) Veröffentlichungstag und Bekanntmachung des Hinweises auf die Patenterteilung: **23.07.2025**
(21) Anmeldenummer: 22765791.3
(22) Anmeldetag: 16.08.2022
(51) Int. Cl.: H02G 5/00, H01R 43/00, H05K 7/14, B60R 16/02, H02M 7/00, H01R 25/00

(54) **ANSCHLUSSTEIL MIT DOPPELTEN STROMSCHIENEN**
CONNECTION PART HAVING DOUBLE BUSBARS
PIÈCE DE RACCORDEMENT À DOUBLE BARRE OMNIBUS

(30) Priorität: 10.09.2021 DE 102021123489
(43) Veröffentlichungstag der Anmeldung: 17.07.2024
(73) Patentinhaber: One Mobility Autokabel GmbH, 72793 Pfullingen (DE)
(72) Erfinder: KASZUBOWSKI, Franz-Heinz, 41849 Wassenberg (DE); SCHLOMS, Martin, 52070 Aachen (DE)
(74) Vertreter: Schönen, Iris
(86) Internationale Anmeldenummer: PCT/EP2022/072824
(87) Internationale Veröffentlichungsnummer: WO 2023/036564

(56) Entgegenhaltungen:
- WO-A1-2017/182129
- WO-A1-2018/110071
- WO-A1-2020/012914
- DE-B3- 102018 216 965
- DE-C- 827 512
- US-A1- 2017 027 074
- US-A1- 2019 036 461

## Beschreibung

Der Gegenstand betrifft ein Anschlussteil, insbesondere für Elektrofahrzeuge, einen Stecker und ein System umfassend Anschlussteil und Stecker.

Das Dokument WO 2017/182129 offenbart ein Anschlussteil nach dem Oberbegriff des Anspruchs 1.

Eine der Herausforderungen der Elektrifizierung der Automobilität liegt in der Übertragung hoher Ströme innerhalb des Fahrzeugs. Insbesondere muss bei elektrisch betriebenen Fahrzeugen üblicherweise ein elektrischer Akkumulator mit hoher Kapazität möglichst schnell aufgeladen werden, vorzugsweise deutlich schneller, als dieser nachher im Fahrbetrieb entladen wird. Dafür müssen die elektrischen Leitungen im Fahrzeug hohe Ladeleistungen mit hohen Strömen und/oder Spannungen transportieren können. Gleichzeitig soll der Raumbedarf, das Gewicht und nicht zuletzt der Preis der Leitungen möglichst gering gehalten werden. Neben der Übertragung elektrischen Stroms ist zudem die Übertragung, Aufnahme und Abgabe von Wärme in dem elektrischen Verteilsystem eine wichtige Aufgabe für die Leitungen.

Insbesondere an Übergängen zwischen verschiedenen elektrischen leitenden Komponenten kann sich ein Übergangswiderstand einstellen, an dem vermehrt Wärme entsteht.

Dem Gegenstand lag dementsprechend die Aufgabe zugrunde, eine möglichst kompakte, leichte und günstige Leitungsanordnung zu schaffen, welche hohe elektrische Leistungen mit möglichst geringem elektrischen Widerstand transportieren kann und zudem vor Überhitzung geschützt ist.

Diese Aufgabe wird gelöst durch ein Anschlussteil nach Anspruch 1, einen Stecker nach Anspruch 14 und ein System nach Anspruch 15

Das gegenständliche Anschlussteil umfasst zumindest zwei Stromschienen. Im Folgenden wird zunächst zumindest eine der Stromschienen beschrieben.

Die Stromschiene weist insbesondere einen im Wesentlichen rechteckigen Querschnitt auf. Der Querschnitt kann zwei einander gegenüberliegende und im Wesentlichen zueinander parallele Breitseiten und zwei im Wesentlichen senkrecht dazu angeordnete, im Wesentlichen zueinander parallele und einander gegenüberliegende Schmalseiten aufweisen. Zumindest eine der Schmalseiten ist insbesondere senkrecht zu zumindest einer der Breitseiten ausgerichtet. Die Stromschiene weist zumindest teilweise eine Längsachse auf. Diese verläuft im Wesentlichen senkrecht zu sowohl den Schmal- als auch den Breitseiten. Die Breitseite ist senkrecht zur Längsachse breiter als die Schmalseite. Eine Breitenerstreckung kann definiert sein als die Breite der Stromschiene in einer Richtung, welche senkrecht zur Längsachse und parallel zur Breitseite verläuft. Auch kann die Breitenerstreckung definiert als die Breite in der Richtung, die senkrecht zur Schmalseite verläuft.

Eine Achse, welche im Wesentlichen senkrecht zur Längsachse und im Wesentlichen parallel zu zumindest einer der Breitseiten der Stromschiene ausgerichtet ist und/oder die im Wesentlichen senkrecht zur Schmalseite der Stromschiene ausgerichtet ist, kann Breitachse genannt werden.

Die Längsachse kann für verschiedene Segmente der Stromschiene verschiedene Ausrichtungen aufweisen. Beispielsweise kann die Stromschiene verformt sein, insbesondere kann die Stromschiene um zumindest eine Breitachse verformt sein. Zumindest zwei voneinander verschiedene Segmente der Stromschiene können folglich voneinander verschieden ausgerichtete Längsachsen aufweisen. Im Falle einer im Wesentlichen geraden Stromschiene kann die Längsachse aller Segmente der Stromschiene im Wesentlichen die gleiche Ausrichtung haben.

Falls die Stromschiene abgelängt ist, lässt sich zudem eine Stirnseite definieren. Zu dieser kann beispielsweise die Längsachse zumindest teilweise im Wesentlichen die Flächennormale bilden. Die Stirnseite kann insbesondere zumindest teilweise senkrecht zu zumindest Teilen der Schmalseiten und zu zumindest Teilen der Breitseiten ausgerichtet sein.

Die Stromschiene ist aus einem elektrisch leitfähigen Material geformt, beispielsweise aus einem Metallwerkstoff. Die Stromschiene kann aus Kupfer, Aluminium, Legierungen hieraus und/oder aus weiteren Metallwerkstoffen geformt sein. Insbesondere kann die Stromschiene aus weichgeglühtem Aluminium geformt sein. Aluminium ist leicht, was für die Anwendung in Fahrzeugen von großem Vorteil ist. Darüber hinaus ist Aluminium im Vergleich zu Kupfer günstiger. Auch kann die Stromschiene aus einem anderen Material geformt sein.

Die Stromschiene kann zumindest teilweise beschichtet sein, beispielsweise mit Silber, Gold, Nickel und/oder Legierungen hieraus und/oder mehrschichtigen Anordnungen dieser und/oder Kombinationen dieser Metallwerkstoffe, beispielsweise mit einer unternickelten Silberbeschichtung.

Der Einsatz einer Stromschiene hat den Vorteil, dass diese durch ihre massive Bauweise mit hohen Querschnitten eine gute Leitfähigkeit für Wärme und elektrischen Strom bereitstellt. Darüber hinaus ist die Wärmekapazität besonders aufgrund des Volumens der Stromschiene hoch. Durch die im Vergleich zu runden Leitern erhöhte Oberfläche bei gleicher Querschnittsfläche kann zudem mehr Wärme über die Oberfläche der Stromschiene abgestrahlt werden.

Zumindest eine der Stromschienen kann einen Querschnitt von mindestens 50 mm², vorzugsweise zwischen 100 und 300 mm² aufweisen. Größere Querschnitte sind ebenfalls möglich, wenn eine besonders hohe elektrische Leistung übertragen und/oder besonders viel Wärme transportiert werden muss.

Für die zumindest zwei Stromschienen kann ein Überlappungsbereich definiert werden. In dem Überlappungsbereich können sich die beiden Stromschienen überlappen. Insbesondere können sich die Stromschienen derart überlappen, dass zumindest eine der Stromschiene mit einer ihrer Breitseiten eine der Breitseiten einer anderen der zumindest zwei Stromschienen überlappt. In dem Überlappungsbereich der zumindest zwei Stromschienen kann also eine Breitseite einer ersten der zumindest zwei Stromschienen mit einer Breitseite einer zweiten der zumindest zwei Stromschienen überlappen. Eine Überlappung kann hierbei bedeuten, dass die zumindest zwei Stromschienen einander bei Draufsicht auf eine der Breiteseiten einer der Stromschienen, insbesondere in Richtung einer Flächennormale auf zumindest eine der Breitseiten zumindest einer der Stromschienen einander zumindest teilweise überdecken.

In dem Überlappungsbereich können zumindest zwei der zumindest zwei Stromschienen einander teilweise überlappen. Auch können zumindest zwei der zumindest zwei Stromschienen einander zumindest in einem Teil des Überlappungsbereichs oder im Wesentlichen im gesamten Überlappungsbereich im Wesentlichen vollständig überlappen.

Die Längsachsen der zumindest zwei Stromschienen können zumindest teilweise parallel zueinander verlaufen. Hierbei können die Längsachsen der zumindest zwei Stromschienen jeweils zumindest teilweise gerade verlaufen. Doch ist für einen parallelen Verlauf der Längsachsen der zumindest zwei Stromschienen nicht notwendig, dass diese jeweils gerade verlaufen. Auch können die jeweiligen Längsachsen der Stromschienen verformt, beispielsweise gebogen sein. Solange die Stromschienen einander in ihrer Verformung folgen und/oder beispielsweise einen konstanten Abstand zueinander bewahren, werden die Längsachsen als parallel zueinander betrachtet.

Die zumindest zwei Stromschienen können zumindest in Teilen des Überlappungsbereichs im Wesentlichen parallel zueinander verlaufen. Insbesondere kann der Abstand zwischen zumindest zwei der zumindest zwei Stromschienen, insbesondere zwischen den Breitseiten der Stromschienen, welche jeweils einer Breitseite einer anderen der zumindest zwei Stromschiene zugewandt sind, zumindest in einem Teil des Überlappungsbereichs im Wesentlichen konstant entlang der Längsachse zumindest einer der Stromschienen sein.

Auch können die Längsachsen der zumindest zwei Stromschienen gegeneinander verkippt sein. Beispielsweise können die Breitseiten der zumindest zwei Stromschienen einander entlang der Längsachse zumindest einer der zumindest zwei Stromschienen voneinander entfernen. Auch können zwei der zumindest zwei Stromschienen mit ihren Breitseiten zumindest im Wesentlichen parallel zueinander ausgerichtet sein, während die Längsachsen der Stromschienen in einer Ebene parallel zu den Breitseiten gegeneinander verkippt sind. Die Stromschienen können auch um ihre jeweilige Längsachse gegeneinander verkippt sein, sodass der Abstand zweier Stromschienen zueinander entlang der Breitachse zumindest einer der Stromschienen variiert, insbesondere auf einer ersten Seite größer ist als auf der entlang der Breitachse gegenüber liegenden zweiten Seite.

Die Breitseiten zumindest zweier der zumindest zwei Stromschienen können mit ihren Breitseiten zumindest in Teilen zumindest im Wesentlichen parallel zueinander ausgerichtet sein.

Neben dem Überlappungsbereich lässt sich ein Endabschnitt definieren. Der Endabschnitt ist verschieden von dem Überlappungsbereich. Der Endabschnitt kann sowohl für jeweils eine Stromschiene definiert sein. Auch kann ein gemeinsamer Endabschnitt der zumindest zwei Stromschienen definiert sein, in dem insbesondere die Endabschnitte zumindest zwei der zumindest zwei Stromschienen angeordnet sind. Insbesondere münden die zumindest zwei Stromschienen mit ihren jeweiligen von dem Überlappungsbereich verschiedenen Endabschnitten in einem gemeinsamen Endabschnitt.

An den zumindest zwei Stromschienen kann jeweils ein Anschlusselement angeordnet sein. Das Anschlusselement ist jeweils in dem Endabschnitt der jeweiligen Stromschiene angeordnet. Bei zumindest zwei Stromschienen und zumindest einem Anschlusselement in jeder der zumindest zwei Stromschienen ergeben sich auch zumindest zwei Anschlusselemente. Die Anschlusselemente der zumindest zwei Stromschienen sind voneinander beabstandet. Insbesondere können die Anschlusselemente zumindest zweier Stromschienen voneinander entlang einer Breitachse zumindest einer der zumindest zwei Stromschienen beabstandet sein. Alternativ oder zusätzlich können die Anschlusselemente entlang einer Flächennormalen auf zumindest eine Breitseite zumindest einer der zumindest zwei Stromschienen beabstandet sein.

Der Endabschnitt zumindest einer der Stromschienen kann insbesondere das Ende einer abgelängten Stromschiene umfassen.

Die Breitenerstreckung des Endabschnitts zumindest einer ersten der zumindest zwei Stromschienen kann im Vergleich zu einer Breitenerstreckung der ersten Stromschiene in zumindest Teilen des Überlappungsbereichs verringert sein. Die Stromschiene kann also in dem Endabschnitt zumindest teilweise eine geringere Breitenerstreckung aufweisen als in dem Überlappungsbereich.

Eine verringerte Breitenerstreckung der Stromschiene im Endabschnitt, anders gesagt eine verringerte Breitenerstreckung des Endabschnitts der Stromschiene, kann insbesondere bei einander zumindest teilweise überlappenden, also beispielsweise übereinander angeordneten, Stromschienen vorteilhaft sein. Die Überlappung kann so insbesondere in dem Endbereich aufgehoben werden.

Die Breitenerstreckung des Endabschnittes einer ersten der zumindest zwei Stromschienen kann derart verringert sein, dass das Anschlusselement der zweiten Stromschiene frei von einer Überlappung durch den Endabschnitt der ersten Stromschiene ist. Hierdurch können die Anschlusselemente der zumindest zwei Stromschienen von einer Breitseite einer der zumindest zwei einander überlappenden Stromschienen erreicht werden.

Die Verringerung der Breitenerstreckung des Endabschnittes einer ersten der zumindest zwei Stromschienen kann das Anschlussteil einer zweiten der zumindest zwei Stromschienen im Wesentlichen vollständig freilegen. Auch kann sie das Anschlussteil teilweise freilegen. Auch kann das Anschlussteil inklusive eines Sicherheitsabstandes um das Anschlussteil herum von der ersten Stromschiene freigelegt sein. Beispielsweise kann der Sicherheitsabstand im Wesentlichen zumindest die Hälfte und/oder die gesamte Breitenerstreckung des Anschlussteils betragen.

Insbesondere können die zumindest zwei Anschlusselemente der zumindest zwei Stromschienen entlang der Längsachse zumindest eines Teils zumindest einer der zumindest zwei Stromschienen im Wesentlichen an der gleichen Position angeordnet sein. Dies kann bedeuten, dass die zumindest zwei Anschlussteile entlang der Längsachse zumindest eines Teils zumindest einer der zumindest zwei Stromschienen im Wesentlichen nicht voneinander beabstandet sind und/oder entlang dieser Achse einen nur sehr geringen und/oder im Wesentlichen keinen Abstand zueinander aufweisen. Die Anschlusselemente können in Draufsicht auf zumindest eine Breitseite zumindest einer der zumindest zwei Stromschienen entlang einer Breitachse beabstandet sein und insbesondere im Wesentlichen nicht entlang der Längsachse.

Durch eine verringerte Breitenerstreckung zumindest einer der zumindest zwei Stromschienen, insbesondere in dem Endabschnitt der Stromschiene, können die Kontaktelemente von zumindest zwei der zumindest zwei Stromschienen von einer Breitseite ausgehend erreicht werden. Es ist also insbesondere nicht notwendig, die Anschlusselemente von zumindest zwei voneinander abgewandten Breitseiten der Stromschienen des Anschlussteils zu kontaktieren. Insbesondere gilt dies für Kontaktelemente, welche nicht entlang der Längsachse zumindest einer der zumindest zwei Stromschienen voneinander beabstandet sind, welche also entlang der Längsachse der zumindest einer der zumindest zwei Stromschienen die gleiche Position aufweisen.

Die Stirnseiten der zumindest zwei Stromschienen können im Wesentlichen zueinander bündig abschließen. Hiermit kann gemeint sein, dass die Stirnseiten der zumindest zwei Stromschienen entlang der Längsachse zumindest einer der zumindest zwei Stromschienen im Wesentlichen an der gleichen Position angeordnet sind. Die Stirnseiten können also entlang der Längsachse zumindest einer der zumindest zwei Stromschienen einen nur sehr geringen und/oder im Wesentlichen keinen Abstand zueinander aufweisen. Dank der verringerten Breitenerstreckung des Endabschnitts zumindest einer der Stromschienen ist es möglich, die zumindest zwei Anschlussteile der zumindest zwei Stromschienen trotz bündig abschließender Stirnseiten der zumindest zwei Stromschienen von einer Breitseite zumindest einer der Stromschienen ausgehend zu kontaktieren.

In einer Ausführungsform sind die Breitenerstreckungen der Endabschnitte zumindest zweier der zumindest zwei Stromschienen verringert. Somit kann, wie oben beschrieben, der Endabschnitt einer ersten Stromschiene eine verringerte Breitenerstreckung aufweisen. Auch kann zusätzlich bei einer zweiten der zumindest zwei Stromschienen eine Breitenerstreckung des Endabschnitts der zweiten Stromschiene im Vergleich zu einer Breitenerstreckung der zweiten Stromschiene in zumindest Teilen des Überlappungsbereichs verringert sein. Insbesondere kann der Endabschnitt derart in seiner Breitenerstreckung verringert sein, dass das Anschlusselement der ersten Stromschiene frei von einer Überlappung durch den Endabschnitt der zweiten Stromschiene ist.

Insbesondere ist sowohl das Anschlussteil einer ersten der zumindest zwei Stromschienen frei von einer Überlappung durch zumindest eine zweite der zumindest zwei Stromschienen und das Anschlussteil einer zweiten der zumindest zwei Stromschienen ist frei von einer Überlappung durch zumindest die erste der zumindest zwei Stromschienen.

Somit können insbesondere zumindest zwei der zumindest zwei Stromschienen jeweils derart in ihrer Breitenerstreckung in ihrem Endabschnitt verjüngt sein, dass das Anschlusselementder jeweils anderen Stromschienen nicht von ihnen verdeckt wird, sie dieses also nicht überlappen.

Nicht nur das Anschlusselement einer Stromschiene kann mittels einer verringerten Breitenerstreckung einer anderen der zumindest zwei Stromschienen freigelegt werden, also von einer Überlappung durch die andere Stromschiene befreit werden. Auch kann zumindest ein Teil des Endabschnitts einer Stromschiene frei von Überlappung durch andere Stromschienen sein.

In einer Ausführungsform kann insbesondere eine Breitenerstreckung des Endabschnitts einer ersten Stromschiene der zumindest zwei Stromschienen im Vergleich zu einer Breitenerstreckung der ersten Stromschiene in zumindest Teilen des Überlappungsbereichs verringert sein. Zusätzlich oder alternativ kann eine Breitenerstreckung des Endabschnitts zumindest einer zweiten der zumindest zwei Stromschienen im Vergleich zu einer Breitenerstreckung der zweiten Stromschiene in zumindest Teilen des Überlappungsbereichs verringert sein. Die Verringerung der Breitenerstreckung der ersten und/oder der zweiten Stromschiene kann derart gestaltet sein, dass zumindest ein Teil des Endabschnitts der zweiten Stromschiene im Wesentlichen frei von einer Überlappung durch den Endabschnitt der ersten Stromschiene ist. Insbesondere kann zumindest ein Teil des Endabschnitts der zweiten Stromschiene über die gesamte Breitenerstreckung, beispielsweise parallel zu einer Breitachse, zumindest eines Teils des Endabschnitts der zweiten Stromschiene frei von einer Überlappung durch die erste Stromschiene sein. Dieser Abschnitt kann das Anschlussteil der zweiten Stromschiene enthalten. Auch kann gleichermaßen zumindest ein Teil des Endabschnitts der ersten Stromschiene im Wesentlichen frei von einer Überlappung durch den Endabschnitt der zweiten Stromschiene sein. Insbesondere kann zumindest ein Teil des Endabschnitts der ersten Stromschiene über die gesamte Breitenerstreckung parallel zu einer Breitachse zumindest eines Teils des Endabschnitts der ersten Stromschiene frei von einer Überlappung durch die zweite Stromschiene sein. Dieser Abschnitt kann das Anschlussteil der ersten Stromschiene enthalten.

Gegenständlich wurde erkannt, dass übereinander geführte Stromschienen verglichen mit nebeneinander geführten Stromschienen mit einer erheblichen Ersparnis an Raumbedarf einhergehen. Gleichzeitig ermöglicht eine Nachbarschaft der Breitseiten zumindest zweier Stromschienen eine Wärmeübertragung zwischen den Stromschienen. Eine lokale Erhitzung einer Stromschiene kann über die benachbarte Stromschiene abgefangen werden. Ein Nachteil übereinander geführter Stromschienen ist die kompliziertere Anschlussgeometrie. Die Breitseiten einander vollständig überlappender Stromschienen können nur von zwei gegenüberliegenden Seiten erreicht werden.

Gegenständlich wurde ferner erkannt, dass eine lokale Verschlankung zumindest einer Stromschiene, insbesondere in einem Endabschnitt, mit einer nur unwesentlich verringerten elektrischen und thermischen Leitfähigkeit der gesamten Stromschiene einhergeht. Dadurch, dass nur ein kleiner Teil der Stromschiene eine verringerte Breitenerstreckung aufweist, behält die gesamte Stromschiene eine hohe Wärmeleitfähigkeit, -kapazität und -abgabefähigkeit. Wärme, welche beispielsweise an im verschlankten Endabschnitt angeordneten Anschlussteilen entsteht, kann von dort in den breiten Überlappungsbereich strömen, dort aufgenommen und abgegeben werden. Die Stromschiene kommt den thermischen und elektrischen Eigenschaften einer durchgehend breiten Stromschiene somit sehr nahe. Insbesondere ist die Das gegenständliche Anschlussteil elektrisch und thermisch deutlich leistungsfähiger als beispielsweise eine Nebeneinanderanordnung zweier Stromschienen, welche jeweils durchgängig die verringerte Breitenerstreckung des gegenständlichen Endabschnitts aufweisen. Gleichzeitig führt die Verringerung der Breitenerstreckung im Endabschnitt zumindest einer Stromschiene zu einer wesentlichen Vereinfachung der Anschlussgeometrie. Denn so können beide Stromschienen von einer gemeinsamen Seite ausgehend an ihren Breitseiten kontaktiert werden. Die Anschlusselemente können entlang der Längsachse der Stromschienen an der gleichen Position angeordnet werden. Auch können die Anschlussteile entlang der Längsachse gegeneinander versetzt sein. Somit ist die Anschlussgeometrie genauso flexibel und unkompliziert wie bei zwei gleichbreiten nebeneinander geführten Stromschienen.

Die Endabschnitt zumindest zweier der zumindest zwei Stromschienen können entlang einer Breitachse zumindest eines Teils zumindest eines Endabschnitts der zumindest zwei Stromschienen voneinander beabstandet sein, insbesondere durch einen Spalt. Beispielsweise kann in einer Draufsicht auf zumindest eine Breitseite der zumindest zwei Stromschienen zwischen den Endabschnitten der Spalt sichtbar sein. Dieser Spalt kann beispielsweise eine isolierende Wirkung zwischen den Stromschienen des Anschlussteils haben.

Für eine Stromschiene kann eine Mittelachse definiert werden. Die Mittelachse kann zwischen den beiden Schmalseiten der Stromschiene verlaufen, insbesondere mittig zwischen den beiden Schmalseiten. Auch kann die Mittelachse mittig zwischen den beiden Breitseiten verlaufen. Insbesondere kann die Mittelachse durch den Mittelpunkt zumindest eines Querschnitts der Stromschiene verlaufen. Der Querschnitt kann in einer Ebene senkrecht zur Längsachse der Stromschiene liegen. Der Mittelpunkt kann hierbei beispielsweise als der Schwerpunkt des Querschnitts bestimmt werden.

Die Mittelachse einer Stromschiene kann sich mit einer Verringerung der Breitenerstreckung der Stromschiene im Vergleich zu einem Bereich der Stromschiene mit voller Breitenerstreckung verschieben. Insbesondere kann die Mittelachse der Stromschiene in dem Überlappungsbereich der Stromschiene verschieden sein von der Mittelachse der Stromschiene in dem Endabschnitt der Stromschiene. Die Mittelachse des Endabschnitts kann exzentrisch zur Mittelachse des Überlappungsbereichs angeordnet sein. Die Mittelachse des Endabschnitts kann insbesondere entlang der Breitachse zumindest eines Teils der Stromschiene relativ zur Mittelachse des Überlappungsbereichs exzentrisch versetzt sein.

Der Endabschnitt zumindest einer der Stromschienen kann relativ zur Mittelachse der Stromschiene in zumindest Teilen des Überlappungsbereichs exzentrisch angeordnet sein.

Insbesondere können die Endabschnitte zweier der zumindest zwei Stromschienen im Wesentlichen jeweils in zueinander entgegengesetzten Richtungen relativ zu der Mittelachse der jeweiligen Stromschiene in zumindest Teilen des Überlappungsbereichs exzentrisch beabstandet sein.

Die Dicke einer Stromschiene lässt sich als die Abmessung der Stromschiene in Richtung der Flächennormalen auf zumindest einen Teil der Breitseite der Stromschiene definieren. Die Dicke bemisst sich also insbesondere senkrecht zur Breitseite der Stromschiene.

Die Dicke einer der zumindest zwei Stromschienen kann im Wesentlichen konstant über zumindest einen Großteil der Stromschiene und/oder über die gesamte Stromschiene sein.

Insbesondere kann eine Ausnehmung in zumindest einer der zumindest zwei Stromschienen die Verringerung der Breitenerstreckung zumindest eines Teils des Endabschnitts der Stromschiene bewirken. Insbesondere kann eine einseitige Ausnehmung in dem Endabschnitt zumindest einer der zumindest zwei Stromschienen die Verringerung der Breitenerstreckung des Endabschnittes bilden. Eine einseitige Ausnehmung verringert die Breitenerstreckung der Stromschiene nur auf einer Seite der Stromschiene. Insbesondere wird von der einseitigen Ausnehmung nur eine der beiden Schmalseiten der Stromschiene in ihrem Verlauf geändert. Eine erste der zwei Schmalseiten der Stromschiene verläuft im Bereich der einseitigen Ausnehmung im Wesentlichen so, wie sie ohne die einseitige Ausnehmung verlaufen würde. Insbesondere kann eine erste Schmalseite im Wesentlichen parallel zur Längsachse der Stromschiene verlaufen. Eine zweite, von der ersten verschiedene Schmalseite der Stromschiene, kann in zumindest einem Abschnitt der Stromschiene, insbesondere in zumindest einem Teil des Endabschnitts, in Richtung der Mittelachse der Stromschiene versetzt sein.

Auch kann zumindest eine der Stromschienen eine geschlossene Öffnung aufweisen, welche das Anschlussteil einer anderen der Stromschienen freilegt. Hierbei können die Schmalseiten der Stromschiene im Wesentlichen parallel zur Längsachse der Stromschiene verlaufen.

In einem Ausführungsbeispiel weisen zumindest zwei der zumindest zwei Stromschienen zumindest in Teilen des Überlappungsbereichs eine im Wesentlichen zueinander gleiche Breitenerstreckung auf.

Insbesondere können zumindest zwei Schmalseiten der zumindest zwei der zumindest zwei Stromschienen in Richtung der Flächennormalen auf zumindest eine Breitseite zumindest einer der zumindest zwei Stromschienen zumindest in einem Teil der zumindest zwei Stromschienen im Wesentlichen bündig miteinander abschließen, insbesondere in dem Überlappungsbereich der Stromschienen. Das Anschlussteil kann also dadurch gekennzeichnet sein, dass zumindest zwei der Schmalseiten der zumindest zwei Stromschienen in Richtung der Flächennormalen auf zumindest eine der Breitseiten zumindest einer der Stromschienen zumindest im Überlappungsbereich im Wesentlichen miteinander bündig abschließen. Auch können jeweils beide Schmalseiten zumindest zweier der zumindest zwei Stromschienen im Wesentlichen miteinander bündig abschließen. Die Stromschienen können sich in dem Fall insbesondere im Wesentlichen vollständig überlappen.

Die Endabschnitte zumindest zweier der Stromschienen können zumindest teilweise die gleiche Breitenerstreckung aufweisen.

Beispielsweise kann die Breitenerstreckung des Endabschnitts zumindest einer der zumindest zwei Stromschienen im Wesentlichen der halben Breitenerstreckung der Stromschiene im Überlappungsbereich entsprechen. Insbesondere kann die Breitenerstreckung des Endabschnitts zumindest einer der zumindest zwei Stromschienen kleiner sein als die halbe Breitenerstreckung der Stromschiene im Überlappungsbereich. Auch können die Breitenerstreckungen der Endabschnitte zumindest zweier Stromschienen jeweils derart dimensioniert sein. Somit können die Endabschnitte in Breitenerstreckung zumindest einer der zumindest zwei Stromschienen voneinander beabstandet sein.

Die Breitenerstreckungen zumindest zweier Endabschnitte jeweils einer von zumindest zwei Stromschienen können in Summe geringer sein, als die Breitenerstreckung zumindest einer der Stromschienen in zumindest einem Teil des Überlappungsbereichs. Die zumindest zwei Breitenerstreckungen der jeweiligen Endabschnitte können dabei zumindest teilweise voneinander verschieden sein.

Die Längsachsen zumindest zweier der zumindest zwei Stromschienen können im Wesentlichen parallel zueinander verlaufen. Insbesondere in dem Bereich des Übergangs zwischen dem Überlappungsbereich und Endabschnitt und/oder dem Endabschnitt können die Längsachsen zumindest zweier der zumindest zwei Stromschienen zueinander parallel verlaufen. Insbesondere können die Breitseiten zumindest zweier der zumindest zwei Stromschienen zueinander parallel ausgerichtet sein. Insbesondere kann der Abstand zwischen zwei der zumindest zwei Stromschienen entlang der Flächennormalen auf zumindest eine Breitseite der zumindest zwei Stromschienen im Wesentlichen konstant sein, insbesondere in zumindest Teilen des Überlappungsbereichs, des Endabschnitts und/oder des Übergangs zwischen Überlappungsbereich und Endabschnitt.

Die Endabschnitte zumindest zweier der zumindest zwei Stromschienen können zueinander entlang der Flächennormalen auf zumindest einen Teil der Breitseite zumindest einer der Stromschienen zumindest teilweise um einen Höhenversatz voneinander beabstandet sein. Beispielsweise kann der Höhenversatz der Endabschnitte zweier Stromschienen dem Abstand zwischen den einander zugewandten Breitseiten der zwei Stromschienen plus der Dicke einer der Stromschiene messen. Insbesondere können die Anschlusselemente zumindest zweier der zumindest zwei Stromschienen voneinander entlang der Flächennormalen auf zumindest eine Breitseite zumindest einer der zumindest zwei Stromschienen voneinander beabstandet sein, insbesondere um den Höhenversatz.

Auch möglich ist es, dass die Endabschnitte zumindest zweier der zumindest zwei Stromschienen zueinander entlang der Flächennormalen auf zumindest eine Breitseite der zumindest zwei Stromschienen einen geringeren zueinander Abstand aufweisen als der Abstand der Stromschienen zueinander in dieser Richtung in zumindest Teilen des Überlappungsbereichs. Somit können insbesondere zumindest zwei der zumindest zwei Stromschienen in dem Endabschnitt zueinander entlang der Flächennormalen auf die Breitseite zumindest eines Teils zumindest einer der zumindest zwei Stromschienen einen geringeren Höhenversatz aufweisen als in zumindest Teilen des Überlappungsbereichs.

Die Endabschnitte zumindest zweier der zumindest zwei Stromschienen können zumindest teilweise im Wesentlichen in einer Ebene liegen. Die Endabschnitte können folglich entlang der Flächennormale auf zumindest einen Teil zumindest einer Breitseite des Endabschnitts zumindest einer der zumindest zwei Stromschienen nur einen geringen und/oder im Wesentlichen keinen Abstand aufweisen. Die zumindest zwei in eine gemeinsame Richtung weisenden Breitseiten der Endabschnitte zumindest zweier der zumindest zwei Stromschienen können zumindest teilweise im Wesentlichen in einer Ebene liegen. Auf diese Weise können auch die Anschlusselemente der zwei der zumindest zwei Stromschienen im Wesentlichen in einer gemeinsamen Ebene liegen.

Zumindest eine der zumindest zwei Stromschienen und/oder die Längsachse zumindest einer der zumindest zwei Stromschienen kann zumindest teilweise einen gebogenen Verlauf aufweisen. Insbesondere kann zumindest eine der zumindest zwei Stromschienen einen zu zumindest einer anderen der zumindest zwei Stromschienen hin gebogenen Verlauf aufweisen, insbesondere einen um eine Breitachse zumindest eines Teils der Stromschienen gebogenen Verlauf. Auf diese Weise können die beiden Stromschienen insbesondere in dem Endabschnitt aneinander angenähert werden.

Insbesondere kann zumindest eine der zumindest zwei Stromschienen zu einer anderen der zumindest zwei Stromschienen hin angenähert sein, insbesondere in dem Endabschnitt. Beispielsweise kann zumindest eine der zumindest zwei Stromschienen in zumindest einem Teil des Überlappungsbereichs, des Endabschnitts, des Übergangsbereichs und/oder mehrerer dieser Bereiche gebogen sein. Insbesondere kann die Stromschiene um eine und/oder mehrere Breitachsen der Stromschiene, beispielsweise im Wesentlichen S-förmig gebogen sein.

Durch die Kombination einer gebogenen Stromschiene mit einer geraden Stromschiene können die Endabschnitte der zumindest zwei Stromschienen zumindest teilweise in einer gemeinsamen Ebene liegen. Insbesondere können die Anschlusselemente in einer gemeinsamen Ebene liegen.

Insbesondere kann die gebogene Stromschiene in zumindest Teilen des Überlappungsbereichs im Wesentlichen eine zu einer anderen der zumindest zwei Stromschienen parallel ausgerichtete Breitseite aufweisen. Auch kann die gebogene Stromschiene in zumindest Teilen des Endabschnitts eine im Wesentlichen zu einer anderen der zumindest zwei Stromschienen parallel ausgerichtete Breitseite aufweisen. Somit sind insbesondere die Bereiche der Endabschnitte zumindest zweier der zumindest zwei Stromschienen, in welchen jeweils ein Anschlusselement angeordnet ist, im Wesentlichen parallel zueinander ausgerichtet.

Auch bei einem Anschlussteil umfassend zumindest eine gebogene Stromschiene und zumindest eine im Wesentlichen gerade verlaufende Stromschiene können die zumindest zwei Stirnseiten der zumindest zwei Stromschienen im Wesentlichen bündig miteinander abschließen, insbesondere in Richtung der Breitenerstreckung und/oder in Richtung der Breitachse zumindest eines der Endabschnitte der zumindest zwei Stromschienen. Die Stirnseiten können also entlang der Längsachse zumindest eines Teil zumindest einer der zumindest zwei Stromschienen des Anschlussteils an der im Wesentlichen gleichen Position liegen und/oder entlang der Längsachse im Wesentlichen nicht beabstandet sein.

Eine gebogene Stromschiene kann länger als eine gerade Stromschiene sein. Insbesondere kann der Endabschnitt einer gebogenen Stromschiene länger sein als der Endabschnitt einer geraden Stromschiene. Dies kann ermöglichen, dass die Stirnseite einer gebogenen Stromschiene und die Stirnseite einer geraden Stromschiene entlang der Längsachse zumindest eines Teil zumindest einer der zumindest zwei Stromschienen an der im Wesentlichen gleichen Position liegen wie oben beschrieben. Der verlängerte Weg der gebogenen Anschlussteils im Bereich der Biegung der gebogenen Stromschiene kann somit durch eine erhöhte Länge der gebogenen Stromschiene und/oder des Endabschnitts der gebogenen Stromschiene ausgeglichen werden.

Der Übergang zwischen zumindest einer Breitseite und/oder zumindest einer Schmalseite mit der Stirnseite der Stromschiene zumindest einer der zumindest zwei Stromschienen kann im Wesentlichen eckig geformt sein. Beispielsweise können die Schmalseiten und/oder Breitseiten jeweils mit der Stirnseite im Wesentlichen einen eckigen Übergang, beispielsweise einen 90-Grad-Übergang bilden. Auch kann zumindest eine der zumindest zwei Stromschienen in einem Endabschnitt eine zumindest teilweise abgerundete Form aufweisen. Beispielsweise kann die Form zumindest einer Breitseite zur Stirnseite der Stromschiene hin im Wesentlichen abgerundet geformt sein. Beispielsweise kann zumindest eine Ecke der Stromschiene abgerundet geformt sein. Ein abgerundeter Endabschnitt der Stromschiene erleichtert ein Einführen der Stromschiene in ein Gehäuse und/oder eine Dichtung.

In einer Ausführungsform weist zumindest eine der zumindest zwei Stromschienen eine Seitenausnehmung auf. Zumindest eine der Stromschienen.kann also mit einer Seitenausnehmung versehen sein. Insbesondere kann die Seitenausnehmung in einem Endabschnitt der Stromschiene angeordnet sein,

Die Seitenausnehmung kann an einer Seite der Stromschiene angeordnet sein, sodass die Seitenausnehmung den ansonsten größtenteils geraden Verlauf der Schmalseite unterbricht.

Für eine Stromschiene, insbesondere für einen Endabschnitt einer Stromschiene lässt sich eine Außenseite definieren. Diese begrenzt entlang der Breitachse zumindest eines Teils zumindest einer der Stromschienen die Kombination aus den zumindest.

Die Seitenausnehmung kann in Außenseite der Stromschiene angeordnet sein.

Die Seitenausnehmung kann entlang der Flächennormale auf eine der Breitseiten der Stromschiene eine konstante Form aufweisen.

Die Kante der Seitenausnehmung kann bei Draufsicht auf die Breitseite zumindest auf einer Seite der Seitenausnehmung im Wesentlichen senkrecht zu der Längskante von dieser ausgehend in die Stromschiene hinein verlaufen. Auch können beide Kanten der Seitenausnehmung im Wesentlichen senkrecht zur Längskante in die Stromschiene hinein verlaufen. Andere Kantenverläufe zumindest einer Seite der Seitenausnehmung sind ebenfalls möglich. So kann die Seitenausnehmung eine oder zwei bei Draufsicht auf die Breitseite in Bezug auf die Schmalseite schräge Kanten aufweisen. Beispielsweise kann zumindest eine der Kanten der Seitenausnehmung in einem Winkel von 30 - 60° relativ zu der Schmalseite abgehen. Insbesondere kann eine Kante im Wesentlichen senkrecht und die andere schräg zur Längskante verlaufen. Die Seitenausnehmung kann derart geformt sein, dass diese bei Draufsicht auf die Breitseite einen Haken und/oder einen Hinterschnitt bildet.

Die Seitenausnehmung kann im Wesentlichen eckig geformt sein, beispielsweise viereckig. Auch kann die Seitenausnehmung abgerundet sein, beispielsweise kann diese im Wesentlichen halbkreisförmig geformt sein. Auch eine Form der Seitenausnehmung als Viertelkreis ist möglich.

Eine Seitenausnehmung kann dazu dienen, die Stromschiene in einer dafür vorgesehenen Halterung zu verrasten. So kann in die Seitenausnehmung ein Rastelement der Verbindungsanordnung eingreifen. Auch kann in die Seitenausnehmung ein anderweitig bewegliches Element, beispielsweise ein Schraubelement eingreifen. Alternativ oder zusätzlich kann die Stromschiene von einem haltenden Element umspritzt werden, beispielsweise von Kunststoff, insbesondere von zumindest Teilen des Gehäuses. Dieses kann in die Seitenausnehmung eingreifen.

Zumindest zwei der Anschlusselemente können entlang der Längsachse zumindest einer der zumindest zwei Stromschienen im Wesentlichen an der gleichen Position angeordnet sein.

Zumindest eines der oder die zumindest zwei Anschlussteile können in dem Endabschnitt der jeweiligen Stromschiene in Bezug auf die Mittelachse des Endabschnitts zentral angeordnet sein. Die Mittelachse kann hierbei bei Draufsicht auf die Breitseite des Endabschnitts mittig in der Breitseite des Endabschnitts entlang der Längsrichtung der Stromschiene verlaufen, sodass sie zu beiden Schmalseiten den im Wesentlichen gleichen Abstand hat. Auch kann das Anschlusselement dezentral und/oder exzentrisch in Bezug auf die Mittelachse des Endabschnitts der Stromschiene an der Stromschiene angeordnet sein. Somit kann zumindest eines der Anschlusselemente im Wesentlichen auf der Mittelachse des Endabschnitts der jeweiligen Stromschiene angeordnet sein. Auch kann zumindest eines der Anschlusselemente im Wesentlichen exzentrisch zu der Mittelachse des Endabschnitts der jeweiligen Stromschiene angeordnet ist.

Insbesondere kann das Anschlusselement in einer Öffnung der Stromschiene angeordnet sein, insbesondere in einer Öffnung im Endabschnitt der Stromschiene.

Insbesondere erstreckt sich die Öffnung der Stromschiene von einer ersten Breitseite zu der der ersten Breitseite gegenüberliegenden zweiten Breitseite der Stromschiene.

Die Öffnung kann beispielsweise als Durchgangsloch geformt sein. Das Durchgangsloch kann einen im Wesentlichen runden Querschnitt aufweisen. Auch möglich ist ein elliptischer, eckiger, insbesondere dreieckiger, viereckiger, fünfeckiger, sechseckiger, mehreckiger, gezackter oder anderweitig geformter Querschnitt des Durchgangslochs. Das Durchgangsloch kann einen im Wesentlichen konstanten Querschnitt entlang der Dicke der Stromschiene aufweisen oder auch einen variablen Querschnitt. Beispielsweise kann sich das Durchgangsloch von einer ersten zu einer zweiten Breitseite hin verjüngen.

Das Anschlussteil kann stoffschlüssig mit der Stromschiene verbunden sein, insbesondere in der Öffnung, insbesondere zumindest teilweise mit der inneren Mantelfläche der Öffnung. Andere Verbindungsarten sind möglich, beispielsweise eine kraftschlüssige und/oder formschlüssige Verbindung. Eine stoffschlüssige Verbindung ist jedoch vorteilhaft für die elektrische und thermische Leitfähigkeit zwischen dem Anschlusselement und der Stromschiene.

Zumindest eines der oder die zumindest zwei Anschlussteile können aus einem elektrisch leitfähigem Material gefertigt sein. Insbesondere kann das Anschlussteil aus einem Metallwerkstoff geformt sein, insbesondere Kupfer, E-Kupfer, Aluminium, Legierungen hiervon und/oder anderen Metallwerkstoffen. Auch ist eine zumindest teilweise oder auch vollständige Beschichtung des Anschlussteils möglich. So kann das Anschlussteil mit Silber, Gold, Nickel und/oder Legierungen und/oder Kombinationen davon beschichtet sein. Insbesondere kann das Anschlussteil aus Kupfer geformt sein, insbesondere E-Kupfer, und zumindest teilweise, insbesondere im Wesentlichen vollständig mit einer unternickelten Silberbeschichtung versehen sein.

Zumindest eines der Anschlusselemente kann sich in einer Erstreckungsrichtung zu einer von der Stromschiene abgewandten Stirnseite des Anschlusselements hin verjüngen. Insbesondere kann die Erstreckungsrichtung des Anschlusselements im Wesentlichen parallel zu der Flächennormale auf zumindest eine Breitseite der Stromschiene ausgerichtet sein.

Zumindest eines der zumindest zwei Anschlusselemente kann in Richtung der Flächennormalen auf die Breitseite zumindest eines Teils der Stromschiene eine größere, kleinere oder im Wesentlichen gleichgroße Länge verglichen mit der Dicke der Stromschiene aufweisen. Insbesondere kann das Anschlussteil die Stromschiene zu einer und/oder beiden Breitseiten in Richtung der Flächennormalen auf die Breitseite zumindest eines Teils der Stromschiene überragen, in dieser versenkt sein und/oder mit dieser im Wesentlichen bündig abschließen.

Das Anschlusselement kann ein Loch aufweisen. Insbesondere kann das Anschlusselement ein Sackloch, insbesondere ein Durchgangsloch aufweisen.

Das Anschlusselement kann als Anschlussbolzen gebildet sein. Ein Anschlussbolzen kann sich beispielsweise ausgehend von der Breitseite der Stromschiene in einer Erstreckungsrichtung erstrecken. Die Erstreckungsrichtung kann beispielsweise im Wesentlichen parallel zur Flächennormalen auf zumindest Teile die Breitseite der Stromschiene, mit der der Anschlussbolzen verbunden ist, ausgerichtet sein. Der Anschlussbolzen kann mit zumindest einer der Breitseiten der Stromschiene im Wesentlichen bündig abschließen, insbesondere sodass er in Erstreckungsrichtung innerhalb der Öffnung endet und/oder die Breitseite nicht überragt. Auch kann der Anschlussbolzen in die Stromschiene hinein versenkt sein. Der Anschlussbolzen kann die Stromschiene auch auf zumindest einer und/oder beiden Breitseiten der Stromschiene in Richtung der Flächennormalen auf zumindest eine der Breitseiten der zumindest zwei Stromschienen überragen. Die Länge das Anschlussbolzens kann insbesondere größer und/oder in Erstreckungsrichtung länger sein als die Dicke der Stromschiene in Richtung der Flächennormalen auf zumindest eine der Breitseiten der zumindest zwei Stromschienen.

Der Anschlussbolzen kann einen im Wesentlichen runden Querschnitt aufweisen. Auch kann der Querschnitt des Anschlussbolzens von einer runden Form abweichen und beispielsweise oval, eckig oder anderweitig von einer runden Form abweichend geformt sein. Der Anschlussbolzen kann einen Kragen aufweisen, mit dem er vorzugsweise auf einer Breitseite der Stromschiene, mit der er in Kontakt steht, kontaktiert. Der Kragen kann von einer runden Form abweichen, beispielsweise eckig geformt sein.

Der Anschlussbolzen kann ein Sackloch, insbesondere ein Durchgangsloch aufweisen.

Das Anschlusselement kann als eine Hülse gebildet sein. Die Hülse weist insbesondere ein Durchgangsloch auf. Die Hülse kann auf einer und/oder auf beiden Breitseiten der Stromschiene in die Öffnung versenkt sein, bündig mit der Breitseite abschließen und/oder die Breitseite überragen, insbesondere in Richtung der Flächennormalen auf die Breitseite. Die Hülse kann zumindest auf einer der beiden Breitseiten einer Stromschiene, mit der die Hülse verbunden ist, einen Kragen aufweisen. Dieser kann die Kante der Öffnung in der Stromschiene, in der die Hülse angeordnet ist, parallel zur Breitseite überragen, insbesondere umläufig um die Öffnung.

In einer Ausführungsform ist zumindest eine Verbindungshülse mit zumindest einem der Anschlusselemente verbunden ist, insbesondere kraftschlüssig, formschlüssig und/oder stoffschlüssig. Beispielsweise kann die Verbindungshülse mittels einer Schraube, welche insbesondere durch das Anschlusselement geführt ist, an dem Anschlusselement befestigt werden. Beispielsweise kann die Verbindungshülse ein Gewinde für die Schraube aufweisen.

Die Verbindungshülse kann aus einem leitfähigen Material, insbesondere aus einem Metallwerkstoff geformt sein, beispielsweise Kupfer, Aluminium, Legierungen hiervon und/oder anderen Metallen. Zumindest eine Beschichtung kann auf der Verbindungshülse aufgebracht sein. Beispielswiese Silber, Gold, Nickel, Legierungen hiervon und/oder mehrschichtige Beschichtungen, beispielsweise eine unternickelte Silberbeschichtung. Insbesondere kann die Verbindungshülse aus dem im Wesentlichen gleichem Material und/oder der gleichen Kombination aus Materialien wie das Anschlussteil geformt sein.

Insbesondere kann die Länge der zumindest einen Verbindungshülse im Wesentlichen dem Höhenversatz der Endabschnitte der zumindest zwei Stromschienen entsprechen. Der Höhenversatz ist hierbei insbesondere wie oben beschrieben parallel zur Flächennormalen auf zumindest Teile der Breitseite zumindest einer der zumindest zwei Stromschienen zu bestimmen. Der Höhenversatz kann dem Abstand zweier in die gleiche Richtung weisenden Breitseiten der Endabschnitte zweier der zumindest zwei Stromschienen zu bestimmen. Mit zumindest einer Verbindungshülse, deren Länge im Wesentlichen dem Höhenversatz zwischen den Endabschnitten zumindest zweier Stromschienen entspricht, kann dieser Höhenversatz ausgeglichen werden.

Auch können zumindest zwei Verbindungshülsen mit jeweils einem Anschlusselement verbunden sein, insbesondere kraftschlüssig, formschlüssig und/oder stoffschlüssig, beispielsweise mittels einer Schraube wie oben beschrieben. Hierbei kann insbesondere der Längenunterschied der zumindest zwei Verbindungshülsen im Wesentlichen dem Höhenversatz der Endabschnitte der zumindest zwei Stromschienen entsprechen.

Das Anschlussteil kann ferner ein Gehäuse umfassen.

Das Gehäuse des Anschlussteils kann insbesondere die zumindest zwei Stromschienen relativ zueinander fixieren, wobei insbesondere die Breitseiten der zumindest zwei Stromschienen zumindest teilweise voneinander beabstandet sind. Beispielsweise kann zumindest ein Teil des Gehäuses zwischen den zumindest zwei Stromschienen angeordnet sein.

Das Gehäuse kann zumindest teilweise aus einem nichtleitenden Material, insbesondere aus einem Kunststoff, insbesondere aus einem Hochtemperaturkunststoff geformt ist, insbesondere aus PA6GF15, UL94.

Der Endabschnitt zumindest einer der zumindest zwei Stromschienen kann in Längsrichtung zumindest einer der Stromschienen zumindest teilweise auf einer Anschlussseite des Gehäuses aus dem Gehäuse herausgeführt sein. Insbesondere kann ein Teil des Endabschnittes in dem Gehäuse angeordnet sein. Auch kann der Endabschnitt vollständig außerhalb des Gehäuses angeordnet sein. Insbesondere kann zumindest eines der Anschlusselemente außerhalb des Gehäuses angeordnet sein. Das Gehäuse kann den Endabschnitt zumindest einer der zumindest zwei Stromschienen auch im Wesentlichen umhüllen. In diesem Fall können Öffnungen im Gehäuse vorgesehen sein, die zumindest eines der Anschlusselemente freilegen. Insbesondere bedeutet freilegen hierbei, dass das Anschlusselement auf gerader Linie, insbesondere in Erstreckungsrichtung, durch die Öffnung erreicht werden kann.

Der Überlappungsbereich zumindest einer der zumindest zwei Stromschienen kann in Längsrichtung zumindest einer der Stromschienen zumindest teilweise auf einer der Anschlussseite abgewandten Verlegeseite des Gehäuses aus dem Gehäuse herausgeführt sein. Der Überlappungsbereich zumindest einer der zumindest zwei Stromschienen kann zumindest teilweise in dem Gehäuse angeordnet sein. Insbesondere ist der Überlappungsbereich größtenteils außerhalb des Gehäuses angeordnet. Auch kann der Überlappungsbereich vollständig außerhalb des Gehäuses angeordnet sein.

Das Anschlussteil kann ferner zumindest eine Dichtung umfassen.

Zumindest eine der zumindest einen Dichtung kann zumindest eine der zumindest zwei Stromschienen umläufig einfassen. Insbesondere kann die Dichtung die zumindest zwei der Stromschienen gemeinsam und/oder einzeln umläufig einfassen. Auch kann die Dichtung insbesondere jede einzelne der zumindest zwei Stromschienen einfassen, insbesondere umläufig. Die Dichtung kann zumindest teilweise oder entlang des vollständigen Umfangs der Stromschiene, die von der Dichtung eingefasst ist, in direktem Kontakt mit der Stromschiene stehen, insbesondere umläufig. Insbesondere kann die Öffnung der Dichtung, in der die jeweilige Stromschiene angeordnet ist, querschnittsangepasst an die Stromschiene sein. Beispielsweise kann die Öffnung der Dichtung im entspannten Zustand, insbesondere ohne Stromschiene, kleiner sein als der Querschnitt der Stromschiene. Durch die Elastizität des Materials der Dichtung kann diese sich umläufig anliegend um die Stromschiene legen.

Eine Dichtung kann zumindest zwei Öffnungen aufweisen. Jede der Öffnungen kann für eine Stromschiene einfassen.

Eine Dichtung kann einen Beabstandungsbereich aufweisen, welcher zwischen zumindest zwei der zumindest zwei Stromschienen angeordnet ist. Der Beabstandungsbereich kann beispielsweise den Abstand der Stromschienen in Richtung der Flächennormale auf zumindest einen Teil der Breitseite zumindest einer der zumindest zwei Stromschienen einstellen.

Der Beabstandungsbereich kann eine Lippe aufweisen, die sich im Wesentlichen parallel zur Breitseite zumindest eines Teils zumindest einer der zumindest zwei Stromschienen erstreckt. Die Lippe kann die restliche Dichtung überragen. Beispielsweise kann die Lippe die restliche Dichtung Richtung des Endabschnittes zumindest einer der Stromschienen überragen.

Zumindest eine der zumindest einen Dichtung kann aus Silikon, Gummi und/oder Kunststoff geformt sein. Beispielsweise kann auch die Dichtung gemeinsam mit dem Gehäuse gespritzt und/oder gegossen sein, insbesondere in einem ZweiKomponenten-Spritzgussverfahren.

Zumindest eine der zumindest einen Dichtung kann zumindest zwei, vorzugsweise drei oder mehr Rippen aufweisen. Die Rippen können auf der Innenfläche der Dichtung, welche in Kontakt mit zumindest einer der Stromschienen kommt angeordnet sein. Zusätzlich oder alternativ können die Rippen auch auf der Außenseite der Dichtung angeordnet sein, welche von der Stromschiene wegweist. Eine Rippe kann beispielsweise als Erhebung der Dichtung gebildet sein, insbesondere als stegfömige Erhebung, welche insbesondere um die Öffnung der Dichtung, welche zumindest eine Stromschiene einfassen kann, angeordnet ist, insbesondere umläufig angeordnet ist.

Das Gehäuse des Anschlussteils kann zumindest eine der zumindest zwei Stromschienen mit zumindest einer Schienenöffnung einfassen, wobei die Schienenöffnung vorzugsweise querschnittsangepasst an die Stromschiene ist. Die Schienenöffnung kann die Stromschiene beispielsweise zumindest teilweise umläufig berühren, beispielsweise unmittelbar oder auch mittelbar, beispielsweise über eine Dichtung.

Zumindest eine der zumindest einen Dichtung kann zumindest teilweise zwischen zumindest einer der zumindest zwei Stromschienen und dem Gehäuse angeordnet sein, insbesondere in Presspassung. Die Dichtung kann beispielsweise in Presspassung zwischen der Stromschiene und dem Gehäuse angeordnet sein.

Das Gehäuse kann zumindest zwei Teilstücke umfassen, welche gemeinsam zumindest eine an zumindest eine der Stromschienen querschnittsangepasste Schienenöffnung formen.

Zumindest eines der zumindest zwei Teilstücke ist im Wesentlichen senkrecht zur Längsachse der zumindest zwei Stromschienen und/oder im Wesentlichen parallel zur Breitseite zumindest einer der Stromschienen auf zumindest eine der zumindest zwei Stromschienen aufsteckbar. Insbesondere kann zumindest eines der Teilstücke ausgehend von der Schmalseite zumindest einer der Stromschienen auf zumindest eine der zumindest zwei Stromschienen aufgesteckt werden.

Zumindest eines der Teilstücke kann beispielsweise zumindest eine Ausnehmung aufweisen, deren Breite an die Dicke der Stromschiene angepasst ist. Beispielsweise kann die Breite der Ausnehmung im Wesentlichen der Dicke der Stromschiene entsprechen. Auch kann die Ausnehmung eine Breite aufweisen, welche größer als die Dicke der Stromschiene ist. Insbesondere kann die Breite der Ausnehmung der Dicke der Kombination aus einer Stromschiene und einer die Stromschiene einfassende Dichtung entsprechen. Auch kann die Ausnehmung eine Breite aufweisen, die der Dicke zumindest zweier Stromschienen entspricht, die zudem von zumindest einer Dichtung umfasst sind. Somit ist es beispielsweise möglich, das Teilstück auf zumindest eine von einer Dichtung umfasste Stromschiene aufzustecken.

Die zumindest zwei Teilstücke des Gehäuses sind aneinander befestigbar. Zumindest eines der zumindest zwei Teilstücke kann einen Steckvorsprung aufweisen und/oder zumindest eines der zumindest zwei Teilstücke kann eine Steckaufnahme aufweisen. Insbesondere kann der Steckvorsprung eines ersten Teilstücks in die Steckaufnahme eines zweiten Teilstücks einführbar sein. Der Steckvorsprung kann querschnittsangepasst an die Steckaufnahme sein. Insbesondere kann der Steckvorsprung im Wesentlichen senkrecht zur Längsachse zumindest eines Teils zumindest einer der zumindest zwei Stromschienen einsteckbar ist. Die Steckaufnahme und/oder der Steckvorsprung, insbesondere in Kombination, ermöglichen eine zumindest formschlüssige Verbindung zwischen den Teilstücken. Auch kann eine kraftschlüssige Verbindung möglich sein.

Ein Steckvorsprung kann beispielsweise eine Erhebung aufweisen. Die Erhebung kann sich in Steckrichtung entlang des Steckvorsprungs erstrecken, beispielsweise als Steg. Die Steckaufnahme kann eine entsprechende Ausnehmung aufweisen. Der Formschluss zwischen Steckvorsprung und Steckvorrichtung ist somit verbessert. Die Steckrichtung kann hierbei die Richtung sein, in der der Steckvorsprung in die Steckaufnahme eingeführt wird.

Der Steckvorsprung und/oder die Steckaufnahme können einen entlang der Steckrichtung im Wesentlichen zumindest teilweise, vorzugsweise im Wesentlichen vollständig konstanten Querschnitt aufweisen. Hierdurch wird auch bei unvollständig eingeschobenem Steckvorsprung ein Formschluss zwischen Steckvorsprung und - aufnahme erreicht werden. Somit hat das Gehäuse in Steckrichtung eine variable Breite.

Die Steckrichtung zumindest eines Paares aus Steckvorsprung und Steckaufnahme verläuft insbesondere im Wesentlichen parallel zu einer Breitseite zumindest einer der Stromschienen.

In einer Ausführungsform weist zumindest ein Teilstück sowohl einen Steckvorsprung als auch eine Steckaufnahme auf. Auch können zumindest zwei Teilstücke jeweils einen Steckvorsprung und eine Steckaufnahme aufweisen.

An zumindest einem der zumindest zwei Teilstücke kann zumindest ein Befestigungsmittel angeordnet sein. Dieses ist insbesondere dazu geeignet, die zumindest zwei Teilstücke miteinander zu verbinden, insbesondere dauerhaft zu verbinden. Das Befestigungsmittel kann insbesondere ein kraftschlüssiges und/oder formschlüssiges Befestigungsmittel sein. Beispielsweise kann das Befestigungsmittel zumindest eine Schraube und/oder zumindest ein Gewinde umfassen. Beispielsweise kann an zumindest einem der Teilstücke eine Schraube befestigbar sein, beispielsweise mittels eines Lochs, insbesondere eines mit einem Einsatz verstärkten Lochs. Beispielsweise kann in dem Loch eine Durchführung eingelassen sein, beispielsweise eine Durchführung aus einem Metallwerkstoff, beispielsweise eine Hülse. In einem der Teilstücke kann beispielsweise eine Schraubenaufnahme angeordnet sein. Eine Schraubenaufnahme kann in das Teilstück eingelassen sein, beispielsweise als Sackloch, Durchgangsloch und/oder als Gewinde, das in das Gehäuse eingelassen ist, insbesondere aus einem Metallwerkstoff.

In einer Ausführungsform ist zumindest eine der zumindest zwei Stromschienen zumindest teilweise isoliert. Insbesondere ist die Stromschiene zumindest teilweise von einer Isolationsschicht umgeben. Insbesondere kann eine Isolationsschicht auf zumindest Teilen einer Breitseite der Stromschiene, welche einer anderen der zumindest zwei Stromschienen zugewandt ist, angeordnet sein.

Zumindest eine der zumindest zwei Stromschienen ist beispielsweise mit einer Isolationsschicht aus einem nichtleitfähigen Material, beispielsweise einem Kunststoff überzogen. Auch möglich ist ein Lack oder eine ähnliche elektrisch nichtleitende Beschichtung.

Insbesondere kann die Stromschiene in Teilen des Überlappungsbereichs isoliert sein. Der isolierte Bereich der Stromschiene kann sich insbesondere von außerhalb des Gehäuses aufseiten der Verlegerichtung bis in das Gehäuse hinein erstrecken.

Ein Teil des Endabschnittes zumindest einer der zumindest zwei Stromschienen kann isoliert sein. Insbesondere kann die Außenseite des Endabschnittes zumindest teilweise isoliert sein. Auch können die Breitseiten des Endabschnittes zumindest teilweise isoliert sein. Falls die Verringerung der Breitenerstreckung des Endabschnittes von einer einseitigen Ausnehmung gebildet wird, kann die Seitenkante im Bereich der Ausnehmung frei von Isolation sein. Das Anschlusselement kann sich in einem abisolierten Bereich des Endabschnitts befinden. Ein stirnseitiger Bereich des Endabschnitts kann insbesondere vollständig abisoliert sein.

Zumindest eine der zumindest zwei Stromschienen kann folglich zumindest in dem Endabschnitt zumindest teilweise abisoliert sein. Insbesondere kann die Außenseite der Stromschiene, insbesondere im Endbereich zumindest teilweise isoliert sein. Auch kann die Innenseite der Stromschiene, welche die andere, von der Außenseite verschiedene Schmalseite der Stromschiene ist, zumindest teilweise abisoliert sein.

Ein weiterer Aspekt betrifft einen Stecker.

Der Stecker umfasst ein Steckergehäuse.

Das Steckergehäuse kann vorzugsweise aus einem nichtleitenden Material geformt sein. Beispielsweise aus Kunststoff, insbesondere einem Hochtemperaturkunststoff. Beispielsweise kann das Steckergehäuse aus dem im Wesentlichen gleichen Material wie das Gehäuse des Anschlussteils geformt sein.

Das Steckergehäuse kann Befestigungsmittel aufweisen. Beispielsweise kann dieses kraftschlüssige und/oder formschlüssige Befestigungsmittel umfassen. Insbesondere kann an dem Steckergehäuse eine Schraubenaufnahme, insbesondere ein Gewinde, wie oben bei dem Gehäuse des Anschlussteils beschrieben, umfassen. Auch kann das Steckergehäuse ein Loch und/oder eine Durchführung für eine Schraube umfassen wie oben für das Gehäuse des Anschlussteils beschrieben.

Zumindest ein Befestigungsmittel kann an dem Anschlussteil, insbesondere an dem Gehäuse des Anschlussteils, und/oder dem Stecker, insbesondere dem Steckergehäuse, angeordnet sein. Insbesondere kann dies ein kraftschlüssiges und/oder formschlüssiges Befestigungsmittel, insbesondere zumindest eine Schraube und/oder zumindest ein Gewinde sein.

Der Stecker kann ferner ein Anschlussteil umfassen, insbesondere ein gegenständliches Anschlussteil wie oben beschrieben. Die zumindest zwei Stromschienen des Anschlussteils können mit jeweils zumindest Teilen eines Endabschnitts in das Steckergehäuse geführt sein.

Insbesondere kann das Gehäuse des Anschlussteils mit dem Steckergehäuse kontaktieren, insbesondere in einem zumindest einer der und/oder die zumindest zwei Stromschienen umläufig umfassenden Bereich kontaktieren.

Zumindest eine Dichtung kann zwischen dem Steckergehäuse und den Gehäuse des Anschlussteils angeordnet sein. Vorzugsweise kann das Gehäuse mittelbar über die Dichtung an dem Steckergehäuse anliegen, vorzugsweise umläufig. Insbesondere kann die Dichtung vorzugsweise in Presspassung zwischen dem Gehäuse des Anschlussteils und dem Steckergehäuse angeordnet sein.

Befestigungsmittel an dem Gehäuse des Anschlussteils und/oder an dem Steckergehäuse können einen Anpressdruck zwischen Gehäuse und Steckergehäuse bewirken. Mittels der Befestigungsmittel kann eine Presspassung der Dichtung zwischen den beiden Gehäusen erwirkt werden.

Ein weiterer Aspekt ist ein System aus einem gegenständlichen Anschlussteil und einem gegenständlichen Stecker.

Insbesondere können die Befestigungsmittel einen Anpressdruck zwischen Gehäuse und Steckergehäuse bewirken, welcher die Dichtung in Presspassung hält.

Im Folgenden wird der Gegenstand der Erfindung anhand einer Ausführungsbeispiele zeigenden Zeichnung näher erläutert. In der Zeichnung zeigen
- Fig. 1: ein gegenständliches Anschlussteil gemäß einem Ausführungsbeispiel;
- Fig. 2: ein gegenständliches Anschlussteil gemäß einem Ausführungsbeispiel.

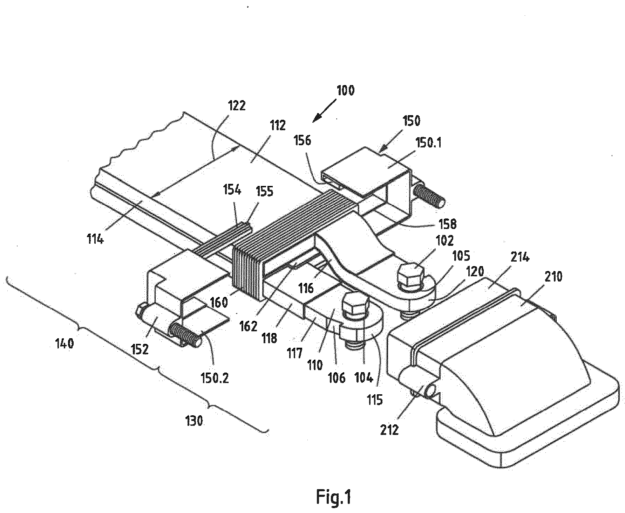

Fig. 1 zeigt ein gegenständliches Anschlussteil 100 gemäß einem Ausführungsbeispiel. Dieses umfasst eine erste Stromschiene 110 und eine zweite Stromschiene 120.

Eine Stromschiene 110, 120 umfasst zwei Breitseiten 112 und zwei Schmalseiten 114. Auch kann eine Stirnseite 115 an dem Ende der Stromschiene 110, 120 definiert werden.

Es lässt sich ein Überlappungsbereich 140 von einem davon getrennten Endabschnitt 130 der Stromschienen 110, 120 unterscheiden.

In dem gezeigten Ausführungsbeispiel überlappen die Stromschienen 110, 120 einander im Überlappungsbereich im Wesentlichen vollständig. Die Stromschienen 110, 120 haben dabei die im Wesentlichen gleiche Breitenerstreckung 122. Die Schmalkanten 114 schließen im Wesentlichen bündig miteinander ab.

In dem Endabschnitt 130 der beiden Stromschienen 110, 120 weisen diese jeweils eine verringerte Breitenerstreckung 122 auf. Insbesondere ist die Breitenerstreckung 122 der Endabschnitte 130 der Stromschienen jeweils geringer als die Hälfte der Breitenerstreckung 122 im Überlappungsbereich 140.

Die erste Stromschiene 110 umfasst ein Anschlusselement 104, die zweite Stromschiene 120 ein Anschlussteil 105. Die Anschlusselemente 104, 105 sind in einem Teil des Endbereichs 130 angeordnet. Die Anschlusselemente 104, 105 sind als Hülse gebildet, welche jeweils in einer Öffnung der jeweiligen Stromschiene 110, 120 angeordnet sind. Das Anschlussteil 104 der ersten Stromschiene 110 steht über die Breitseite 112 der Stromschiene 110 hinaus. Das Anschlussteil 105 der zweiten Stromschiene 120 ist in der Öffnung der Stromschiene 120 versenkt. In den Anschlusselementen 104, 105 sind Schrauben 102 angeordnet.

Auch zu erkennen ist, dass die Stromschienen 110, 120 jeweils eine Seitenausnehmung 106 aufweisen. Diese ist hakenförmig ausgeführt. Insbesondere ist die Kante der Seitenausnehmung 106, welche zum stirnseitigen Ende der Stromschienen 110, 120 weist, zumindest teilweise steil, insbesondere im Wesentlichen senkrecht zur Außenseite 117 der Stromschiene 110, 120 in die Breitseite 112 der Stromschiene 110, 120 hineingeführt. Die Kante der Seitenausnehmung 106, welche dem Überlappungsbereich der Stromschienen 110, 120 zugewandt ist, ist weniger steil, insbesondere in einem flachen Winkel zur Außenseite 117 von beispielsweise 45 Grad oder weniger in die Breitseite 112 der Stromschiene 110, 120 hineingeführt sein.

Das Ende der Stromschienen ist abgerundet. Die Stirnseite 115 ist somit keine plane Fläche sondern beschreibt einen Bogen. Hierdurch können die Stromschienen mit geringerem Widerstand in eine entsprechende aufnehmende Umgebungen eingeführt werden.

Die zweite Stromschiene 120 ist gebogen ausgeführt. In dem gezeigten Ausführungsbeispiel ist die Stromschiene 120 S-förmig gebogen ausgeführt. Insbesondere weist das stirnseitige Ende des Endabschnitts 130 der Stromschiene 120 die im Wesentlichen gleiche Ausrichtung der Breitseite 112 auf wie in dem Überlappungsbereich 140.

Durch die Biegung der zweiten Stromschiene 120 liegen die Endabschnitt 130 der beiden Stromschienen 110, 120 im Wesentlichen in einer Ebene. Insbesondere können auch die in den Stromschienen 110, 120 angeordneten Anschlusselemente 104, 105 in einer Ebene liegen.

Die Stromschienen 110, 120 können jeweils zumindest teilweise isoliert sein. Insbesondere kann eine Isolationsschicht 118 auf Teilen der Oberfläche der Stromschienen 110, 120 angeordnet sein. In dem Überlappungsbereich 140 können die Stromschienen im Wesentlichen vollständig isoliert sein. Auch können die Stromschienen 110, 120 in Teilen des Endabschnitts 130 abisoliert sein. Gezeigt ist eine Abisolierung an den stirnseitigen Enden der Stromschienen, die insbesondere die Anschlusselemente 104, 105 beherbergen. Die Isolation 118 ist ferner an den Innenseiten 116 entfernt.

Das Anschlussteil 100 umfasst ferner eine Dichtung 160. Die Dichtung kann wie gezeigt sowohl die Stromschienen 110, 120 einzeln umschließen als auch diese gemeinsam umschließen. Die Dichtung 160 kann querschnittsangepasste Öffnungen für die Stromschienen 110, 120 aufweisen. An der Dichtung 160 sind mehrere Rippen zu erkennen. Diese sind außenumfänglich an der Dichtung 160 angeordnet.

Auch zu erkennen ist, dass die Dichtung eine Lippe 162 aufweist. Die Lippe 162 ist zwischen den Stromschienen 110, 120 angeordnet. Insbesondere ist die Lippe 110, 120 zwischen den Breitseiten angeordnet und erstreckt sich im Wesentlichen parallel zu der Breitseite 112 zumindest einer der Stromschienen 110, 120 in Richtung des Endabschnittes 130 und/oder Endes der Stromschienen 110, 120. Die Lippe 162 kann die restliche Dichtung 160 in Richtung des Endes und/oder des Anschlusselements 104, 105 zumindest einer der Stromschienen 110, 120 überragen. Die Lippe 162 kann als Abstandshalter dienen. Insbesondere kann die gebogene zweite Stromschiene 120 an zumindest Teilen der Lippe 162, insbesondere an Teilen des engabschnittseitigen Stirnbereichs der Lippe 162 anliegen.

Auch ist auf Fig. 1 ein Gehäuse 150 zu erkennen. Das Gehäuse 150 weist insbesondere zwei Teilstücke 150.1, 150.2 auf. Die Teilstücke 150.1, 150.2 können gemeinsam eine Öffnung für die beiden Stromschienen 110, 120 bilden.

Die Teilstücke 150.1, 150.2 sind miteinander verbindbar. Insbesondere weist ein Teilstück 150.2 zumindest einen Steckvorsprung 154 auf und ein Teilstück 150.1 zumindest eine Steckaufnahme 156 auf. Insbesondere weißt jedes der Teilstücke sowohl eine Steckaufnahme 156 als auch einen Steckvorsprung 154 auf. Diese können jeweils auf gegenüberliegenden Breitseiten 112 der übereinander angeordneten Stromschienen 110, 120 angeordnet sein.

Der Steckvorsprung 154 ist in die Steckaufnahme 156 einsteckbar. Insbesondere ist die Steckaufnahme 156 querschnittsangepasst an den Steckvorsprung 154. Der Steckvorsprung 154 und die Steckaufnahme 156 erstrecken sich entlang einer Erstreckungsrichtung, welche insbesondere parallel zur Breitseite der Stromschiene und/oder senkrecht zur Längsachse zumindest einer der zwei Stromschienen verläuft.

Der Steckvorsprung 154 und/oder die Steckaufnahme 156 können wie gezeigt auf der dem Überlappungsbereich zugewandten Seite des Gehäuses 150 angeordnet sein.

Der Steckvorsprung 154 kann eine Erhebung 155 entlang der Steckrichtung aufweisen. Die Erhebung 155 kann wie gezeigt stegförmig ausgebildet sein. Die Erhebung 155 kann sich entlang der Steckrichtung erstrecken. Die Steckaufnahme 155 kann eine entsprechende Nut für die Aufnahme der Erhebung 155 aufweisen.

Das Gehäuse 150, insbesondere zumindest einer der Gehäuseteile 150.1, 150.2 kann eine Erhebung 158 an der inneren Mantelfläche aufweisen. Die Erhebung 158 kann als stegförmige Erhebung 158, insbesondere umläufige stegförmige Erhebung 158 geformt sein. Die Erhebung 158 kann zwischen zumindest zwei der Rippen der Dichtung 160 eingreifen.

An dem Gehäuse 150 können Befestigungsmittel 152 angeordnet sein. An jedem der Teilstücke 150.1, 150.2 können jeweils Befestigungsmittel 152 angeordnet sein. Beispielsweise können die Befestigungsmittel wie gezeigt Schrauben umfassen. Zumindest eine Schraube kann durch ein Loch in dem Gehäuse 150 geführt sein. Insbesondere kann die Schraube verliersicher an dem Gehäuse angeordnet sein.

Neben dem Gehäuse 150 kann ein Steckergehäuse 210 vorgesehen sein. Dieses kann Befestigungsmittel 212 umfassen. Die Befestigungsmittel des Gehäuses 150 können an mit den Befestigungsmitteln 212 des Steckergehäuses 210 befestigbar sein. Beispielsweise kann wie gezeigt das Steckergehäuse 210 Löcher als Befestigungsmittel aufweisen, in die Schrauben 152 des Gehäuses 150 eingeschraubt werden können.

Das Gehäuse 150 kann in der Längsachse zumindest einer der Stromschienen 110, 120 eine höhere Erstreckung aufweisen als die Dichtung 160 in dieser Richtung. Die Dichtung 160 kann vollständig von dem Gehäuse 150 umfasst sein.

Das Gehäuse 150 kann in dem zum Endabschnitt 130 weisenden Bereich einen größeren Querschnitt aufweisen als in einem dem Überlappungsbereich 140 zugewandten Bereich. Insbesondere kann zwischen den Stromschienen 110, 120 und/oder zwischen der Dichtung 160 und dem Gehäuse 150 ein umläufiger Spalt freibleiben. In diesen Spalt kann eine Mantelfläche 214 des Steckergehäuses 210 eingeführt werden. Insbesondere kann die Mantelfläche 214 mit der Dichtung 160 kontaktieren. Somit ist eine wasserdichte, gasdichte und/oder druckdichte Verbindung zwischen dem Gehäuse 150 und dem Steckergehäuse 210 möglich.

Die Stromschienen 110, 120 können wasserdicht, gasdicht und/oder druckdicht in das Gehäuse 210 eingeführt werden.

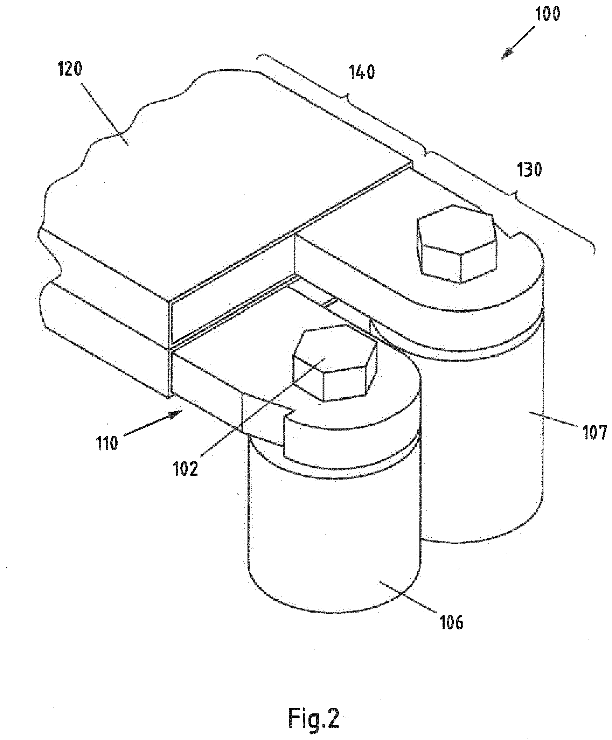

Fig. 2 zeigt eine weitere Ausführung des gegenständlichen Anschlussteils gemäß eines Ausführungsbeispiels.

Die Stromschienen 110, 120 verlaufen parallel zueinander. Die Stromschienen 110, 120 sind in dem Überlappungsbereich 140 teilweise gebogen. In dem Endabschnitt 130 hingegen sind beide Stromschienen 110, 120 gerade entlang einer gemeinsamen Längsachse geführt. Der Endabschnitt kann im Vergleich zur Bauform aus Fig. 1 mit einer gebogenen Stromschiene 120 kürzer ausfallen.

Da die Stromschienen 110, 120 nicht gebogen sind, sind die Endabschnitte der jeweiligen Stromschienen 110, 120 entlang der Flächennormalen auf zumindest einen Teil die Breitseite 112 zumindest einer der Stromschienen um einen Höhenversatz voneinander beabstandet.

Verbindungshülsen 106, 107 können dazu dienen, den Höhenversatz auszugleichen. Die Verbindungshülsen 106, 107 erstrecken sich in einer Erstreckungsrichtung, die im gezeigten Fall im Wesentlichen senkrecht zur Breitseite der jeweiligen Endabschnitt der Stromschienen 110, 120 verlaufen. Die Endabschnitten abgewandten Enden der Verbindungshülsen 106, 107 befinden sich im Wesentlichen entlang der Erstreckungsrichtung zumindest einer der Verbindungshülsen 106, 107 an der gleichen Position.

## Patentansprüche

1. Anschlussteil umfassend
- zumindest zwei Stromschienen, wobei in einem Überlappungsbereich der zumindest zwei Stromschienen eine Breitseite einer ersten der zumindest zwei Stromschienen mit einer Breitseite einer zweiten der zumindest zwei Stromschienen überlappt und die Längsachsen der zumindest zwei Stromschienen in zumindest Teilen des Überlappungsbereichs im Wesentlichen parallel zueinander verlaufen, und
- die zumindest zwei Stromschienen mit ihren jeweiligen von dem Überlappungsbereich verschiedenen Endabschnitten in einem gemeinsamen Endabschnitt münden, und
- zumindest ein an jeweils einer der zumindest zwei Stromschienen in dem Endabschnitt der Stromschiene angeordnetes Anschlusselement, wobei die Anschlusselemente der zumindest zwei Stromschienen voneinander beabstandet sind, wobei
- eine Breitenerstreckung des Endabschnitts zumindest der ersten Stromschiene im Vergleich zu einer Breitenerstreckung der ersten Stromschiene in zumindest Teilen des Überlappungsbereichs verringert ist, derart, dass das Anschlusselement der zweiten Stromschiene frei von einer Überlappung durch den Endabschnitt der ersten Stromschiene ist
**dadurch gekennzeichnet, dass**
- zumindest eine Dichtung zumindest eine der zumindest zwei Stromschienen umläufig umfasst.

2. Anschlussteil nach einem der vorangehenden Ansprüche,
**dadurch gekennzeichnet, dass**
- eine Breitenerstreckung des Endabschnitts der zweiten Stromschiene im Vergleich zu einer Breitenerstreckung der zweiten Stromschiene in zumindest Teilen des Überlappungsbereichs verringert ist, derart, dass das Anschlusselement der ersten Stromschiene frei von einer Überlappung durch den Endabschnitt der zweiten Stromschiene ist.

3. Anschlussteil nach einem der vorangehenden Ansprüche,
**dadurch gekennzeichnet, dass**
- der Endabschnitt zumindest einer der Stromschienen relativ zur Mittelachse der Stromschiene in zumindest Teilen des Überlappungsbereichs exzentrisch angeordnet ist und/oder eine einseitige Ausnehmung der Stromschiene die Verringerung der Breitenerstreckung des Endabschnittes bildet.

4. Anschlussteil nach einem der vorangehenden Ansprüche,
**dadurch gekennzeichnet, dass**
- die Schmalseiten der zumindest zwei Stromschienen in Richtung der Flächennormalen auf zumindest eine der Breitseiten zumindest einer der Stromschienen zumindest im Überlappungsbereich im Wesentlichen miteinander bündig abschließen und/oder
- dass die Stirnseiten der zumindest zwei Stromschienen entlang der Längsachse zumindest einer der Stromschienen an der im Wesentlichen gleichen Position angeordnet sind.

5. Anschlussteil nach einem der vorangehenden Ansprüche,
**dadurch gekennzeichnet, dass**
- zumindest zwei der zumindest zwei Stromschienen in dem Endabschnitt zueinander entlang eine Flächennormalen auf zumindest eine Breitseite zumindest einer der Stromschienen einen geringeren Abstand aufweisen als in dem Überlappungsbereich, insbesondere dass die Endabschnitte zumindest zweier der Stromschienen zumindest teilweise im Wesentlichen in einer Ebene liegen.

6. Anschlussteil nach einem der vorangehenden Ansprüche,
**dadurch gekennzeichnet, dass**
- zumindest eine der Stromschienen mit einer Seitenausnehmung versehen ist, insbesondere in einem Endabschnitt, insbesondere in einer Außenseite der Stromschiene.

7. Anschlussteil nach einem der vorangehenden Ansprüche,
**dadurch gekennzeichnet, dass**
- die zumindest zwei der Anschlusselemente entlang der Längsachse zumindest einer der zumindest zwei Stromschienen im Wesentlichen an der gleichen Position angeordnet sind und/oder
- zumindest eines der Anschlusselemente im Wesentlichen auf der Mittelachse des Endabschnitts der jeweiligen Stromschiene angeordnet ist oder
- dass zumindest eines der Anschlusselemente im Wesentlichen exzentrisch zu der Mittelachse des Endabschnitts der jeweiligen Stromschiene angeordnet ist.

8. Anschlussteil nach einem der vorangehenden Ansprüche,
**dadurch gekennzeichnet, dass**
- das Anschlusselement als Anschlussbolzen gebildet ist und/oder dass das Anschlusselement als eine Hülse gebildet ist.

9. Anschlussteil nach einem der vorangehenden Ansprüche,
**dadurch gekennzeichnet, dass**
- zumindest eines der Anschlusselemente sich in einer Erstreckungsrichtung zu einer von der Stromschiene abgewandten Stirnseite des Anschlusselements hin verjüngt.

10. Anschlussteil nach einem der vorangehenden Ansprüche,
**dadurch gekennzeichnet, dass**
- zumindest eines der zumindest zwei Anschlusselemente ein Durchgangsloch aufweist, insbesondere in Richtung der Flächennormalen auf zumindest Teile der Breitseite der Stromschiene.

11. Anschlussteil nach einem der vorangehenden Ansprüche,
**dadurch gekennzeichnet, dass**
- zumindest eine Verbindungshülse mit zumindest einem der Anschlusselemente verbunden ist, insbesondere kraftschlüssig, formschlüssig und/oder stoffschlüssig, beispielsweise mittels einer Schraube, wobei insbesondere die Länge der zumindest einen Verbindungshülse im Wesentlichen dem Höhenversatz der Endabschnitte der zumindest zwei Stromschienen entspricht und/oder
- dass zumindest zwei Verbindungshülsen mit jeweils einem Anschlusselement verbunden sind, insbesondere kraftschlüssig, formschlüssig und/oder stoffschlüssig, beispielsweise mittels einer Schraube, wobei insbesondere der Längenunterschied der zumindest zwei Verbindungshülsen im Wesentlichen dem Höhenversatz der Endabschnitte der zumindest zwei Stromschienen entspricht.

12. Anschlussteil nach einem der vorangehenden Ansprüche,
**dadurch gekennzeichnet, dass**
- die zumindest eine Dichtung die zumindest zwei Stromschienen gemeinsam und/oder einzeln umläufig umfasst, bevorzugt
- zumindest eine der zumindest einen Dichtung aus Silikon, Gummi und/oder Kunststoff geformt ist, insbesondere dass das Gehäuse und die Dichtung gemeinsam gespritzt und/oder gegossen ist, insbesondere in einem ZweiKomponenten-Spritzgussverfahren und/oder bevorzugt
- zumindest eine der zumindest einen Dichtung zumindest zwei, vorzugsweise drei oder mehr Rippen aufweist.

13. Anschlussteil nach einem der vorangehenden Ansprüche,
**dadurch gekennzeichnet, dass**
- das Gehäuse zumindest eine der zumindest zwei Stromschienen mit zumindest einer Schienenöffnung einfasst, wobei die Schienenöffnung vorzugsweise querschnittsangepasst an die Stromschiene ist, wobei das Gehäuse insbesondere zumindest zwei Teilstücke umfasst, welche gemeinsam zumindest eine an zumindest eine der Stromschienen querschnittsangepasste Schienenöffnung formen, bevorzugt
- zumindest eines der zumindest zwei Teilstücke im Wesentlichen senkrecht zur Längsachse der zumindest zwei Stromschienen und/oder im Wesentlichen parallel zur Breitseite zumindest einer der Stromschienen auf zumindest eine der zumindest zwei Stromschienen aufsteckbar ist, insbesondere ausgehend von der Schmalseite zumindest einer der Stromschienen und besonders bevorzugt
- zumindest eines der zumindest zwei Teilstücke einen Steckvorsprung aufweist und/oder zumindest eines der zumindest zwei Teilstücke eine Steckaufnahme aufweist, wobei insbesondere der Steckvorsprung in die Steckaufnahme einführbar ist, insbesondere im Wesentlichen senkrecht zur Längsachse zumindest eines Teils zumindest einer der zumindest zwei Stromschienen einsteckbar ist und/oder
- dass zumindest ein Befestigungsmittel an zumindest einem der zumindest zwei Teilstücke angeordnet sind, welches die zumindest zwei Teilstücke miteinander verbindet, insbesondere ein kraftschlüssiges und/oder formschlüssiges Befestigungsmittel, insbesondere zumindest eine Schraube und/oder zumindest ein Gewinde.

14. Stecker mit
- einem Steckergehäuse,
- einem Anschlussteil nach einem der vorangehenden Ansprüche, wobei die zumindest zwei Stromschienen mit jeweils einem Endabschnitt in das Steckergehäuse geführt sind und das Gehäuse des Anschlussteils mit dem Steckergehäuse in einem die Stromschienen umläufig umfassenden Bereich kontaktiert, vorzugsweise mittelbar über eine Dichtung, welche vorzugsweise in Presspassung zwischen dem Gehäuse des Anschlussteils und dem Steckergehäuse angeordnet ist und bevorzugt - zumindest ein Befestigungsmittel an dem Anschlussteil, insbesondere an dem Gehäuse des Anschlussteils, und/oder dem Stecker, insbesondere dem Steckergehäuse, angeordnet ist, insbesondere ein kraftschlüssiges und/oder ein formschlüssiges Befestigungsmittel, insbesondere zumindest eine Schraube und/oder zumindest ein Gewinde.

15. System mit einem Anschlussteil nach Anspruch 1 - 13 und einem Stecker nach Anspruch 14.

## Claims

1. Connection part comprising
- at least two busbars, wherein a broad face of a first of the at least two busbars overlaps with a broad face of a second of the at least two busbars in an overlap region of the at least two busbars, and the longitudinal axes of the at least two busbars runs substantially parallel to one another in at least parts of the overlap region, and
- the at least two busbars open into a common end portion with their corresponding end portions different from the overlap region, and
- at least one connection element arranged in each case on one of the at least two busbars in the end portion of the busbar, the connection elements of the at least two busbars being spaced apart from one another,
- a width of the end portion of at least the first busbar being reduced in relation to a width of the first busbar in at least parts of the overlap region in such a way that the connection element of the second busbar is free of overlap by the end portion of the first busbar
**characterized in that**
- at least one seal surrounds at least one of the at least two busbars.

2. Connection part according to any of the preceding claims,
**characterized in that**
- a width of the end portion of the second busbar is reduced in comparison with a width of the second busbar in at least parts of the overlap region in such a way that the connection element of the first busbar is free of overlap by the end portion of the second busbar.

3. Connection part according to any of the preceding claims,
**characterized in that**
- the end portion of at least one of the busbars is arranged eccentrically relative to the central axis of the busbar in at least parts of the overlap region and/or a one-sided recess of the busbar forms the reduction in the width of the end portion.

4. Connection part according to any of the preceding claims,
**characterized in that**
- the narrow faces of the at least two busbars terminate in a substantially flush manner in the direction of the surface normal to at least one of the broad faces of at least one of the busbars at least in the overlap region, and/or
- the end faces of the at least two busbars are arranged along the longitudinal axis of at least one of the busbars at substantially the same position.

5. Connection part according to any of the preceding claims,
**characterized in that**
- at least two of the at least two busbars in the end portion have a smaller distance from one another along a surface normal to at least one broad face of at least one of the busbars than in the overlap region, in particular **in that** the end portions of at least two of the busbars are at least partially located in a plane.

6. Connection part according to any of the preceding claims,
**characterized in that**
- at least one of the busbars is provided with a side recess, in particular in an end portion, in particular in an outer face of the busbar.

7. Connection part according to any of the preceding claims,
**characterized in that**
- the at least two of the connection elements are arranged substantially at the same position along the longitudinal axis of at least one of the at least two busbars and/or
- at least one of the connection elements is arranged substantially on the central axis of the end portion of the corresponding busbar or
- **in that** at least one of the connection elements is arranged substantially eccentrically with respect to the central axis of the end portion of the corresponding busbar.

8. Connection part according to any of the preceding claims,
**characterized in that**
- the connection element is formed as a connection bolt and/or **in that** the connection element is formed as a sleeve.

9. Connection part according to any of the preceding claims,
**characterized in that**
- at least one of the connection elements tapers in an extension direction toward an end face of the connection element facing away from the busbar.

10. Connection part according to any of the preceding claims,
**characterized in that**
- at least one of the at least two connection elements has a through-hole, in particular in the direction of the surface normal to at least parts of the broad face of the busbar.

11. Connection part according to any of the preceding claims,
**characterized in that**
- at least one connecting sleeve is connected to at least one of the connection elements, in particular with a force fit, with a form fit and/or in a material-locking manner, for example by means of a screw, in particular the length of the at least one connecting sleeve substantially corresponding to the vertical offset of the end portions of the at least two busbars, and/or
- **in that** at least two connecting sleeves are in each case connected to a connection element, in particular with a force fit, with a form fit and/or in a material-locking manner, for example by means of a screw, in particular the difference in length of the at least two connecting sleeves substantially corresponding to the vertical offset of the end portions of the at least two busbars.

12. Connection part according to any of the preceding claims,
**characterized in that**
- the at least one seal surrounds the at least two busbars together and/or individually, preferably
- at least one of the at least one seal is formed from silicone, rubber, and/or a plastics material, in particular **in that** the housing and the seal are injection molded and/or cast together, in particular in a two-component injection molding process and/or preferably
- at least one of the at least one seal has at least two, preferably three or more ribs.

13. Connection part according to any of the preceding claims,
**characterized in that**
- the housing surrounds at least one of the at least two busbars with at least one busbar opening, the busbar opening preferably being adapted in cross section to the busbar, the housing in particular comprising at least two partial pieces that jointly form at least one busbar opening adapted in cross section to at least one of the busbars, preferably
- at least one of the at least two partial pieces can be plugged onto at least one of the at least two busbars substantially perpendicular to the longitudinal axis of the at least two busbars and/or substantially parallel to the broad face of at least one of the busbars, in particular starting from the narrow face of at least one of the busbars and particular preferably
- at least one of the at least two partial pieces has a plug projection and/or at least one of the at least two partial pieces has a plug receptacle, in particular the plug projection being insertable into the plug receptacle, in particular being insertable substantially perpendicular to the longitudinal axis of at least one part of at least one of the at least two busbars, and/or
- **in that** at least one fastening means is arranged on at least one of the at least two partial pieces, which fastening means connects the at least two partial pieces to one another, in particular a force-fitting and/or form-fitting fastening means, in particular at least one screw and/or at least one thread.

14. Plug having
- a plug housing,
- a connection part according to any of the preceding claims, the at least two busbars being guided in each case with one end portion into the plug housing and the housing of the connection part contacting the plug housing in a region that surrounds the busbars, preferably indirectly via a seal that is preferably arranged in a press fit between the housing of the connection part and the plug housing and preferably
- at least one fastening means is arranged on the connection part, in particular on the housing of the connection part, and/or the plug, in particular the plug housing, in particular a force-fitting and/or a form-fitting fastening means, in particular at least one screw and/or at least one thread.

15. System having a connection part according to claim 1-13 and a plug according to claim 14.

## Revendications

1. Partie de raccordement comprenant
- au moins deux rails conducteurs, dans laquelle, dans une zone de chevauchement des au moins deux rails conducteurs, un côté large d'un premier parmi les au moins deux rails conducteurs chevauche un côté large d'un second parmi les au moins deux rails conducteurs et les axes longitudinaux des au moins deux rails conducteurs s'étendent sensiblement parallèlement l'un à l'autre dans au moins des parties de la zone de chevauchement, et
- les au moins deux rails conducteurs débouchent avec leurs sections d'extrémité respectives différentes de la zone de chevauchement dans une section d'extrémité commune, et
- au moins un élément de raccordement disposé sur respectivement l'un des au moins deux rails conducteurs dans la section d'extrémité du rail conducteur, dans laquelle les éléments de raccordement des au moins deux rails conducteurs sont espacés l'un de l'autre, dans laquelle
- une extension en largeur de la section d'extrémité d'au moins le premier rail conducteur est réduite par rapport à une extension en largeur du premier rail conducteur dans au moins des parties de la zone de chevauchement, de telle sorte que l'élément de raccordement du second rail conducteur est exempt de chevauchement par la section d'extrémité du premier rail conducteur
**caractérisée en ce que**
- au moins un joint d'étanchéité entoure au moins l'un des au moins deux rails conducteurs.

2. Partie de raccordement selon l'une des revendications précédentes,
**caractérisée en ce que**
- une extension en largeur de la section d'extrémité du second rail conducteur est réduite par rapport à une extension en largeur du second rail conducteur dans au moins des parties de la zone de chevauchement, de telle sorte que l'élément de raccordement du premier rail conducteur est exempt de chevauchement par la section d'extrémité du second rail conducteur.

3. Partie de raccordement selon l'une des revendications précédentes,
**caractérisée en ce que**
- la section d'extrémité d'au moins l'un des rails conducteurs est disposée de manière excentrée par rapport à l'axe central du rail conducteur dans au moins des parties de la zone de chevauchement et/ou un évidement unilatéral du rail conducteur forme la réduction de l'extension en largeur de la section d'extrémité.

4. Partie de raccordement selon l'une des revendications précédentes,
**caractérisée en ce que**
- les côtés étroits des au moins deux rails conducteurs se terminent sensiblement en affleurement l'un avec l'autre dans la direction de la normale à la surface sur au moins l'un des côtés larges d'au moins l'un des rails conducteurs, au moins dans la zone de chevauchement, et/ou
- **en ce que** les faces frontales des au moins deux rails conducteurs sont disposées dans la position sensiblement identique le long de l'axe longitudinal d'au moins l'un des rails conducteurs.

5. Partie de raccordement selon l'une des revendications précédentes, **caractérisée en ce que**
- au moins deux des au moins deux rails conducteurs présentent, dans la section d'extrémité, une distance plus faible l'un par rapport à l'autre le long d'une normale à la surface sur au moins un côté large d'au moins l'un des rails conducteurs que dans la zone de chevauchement, **en particulier en ce que** les sections d'extrémité d'au moins deux des rails conducteurs se trouvent au moins partiellement sensiblement dans un plan.

6. Partie de raccordement selon l'une des revendications précédentes,
**caractérisée en ce que**
- au moins l'un des rails conducteurs est pourvu d'un évidement latéral, en particulier dans une section d'extrémité, en particulier dans un côté extérieur du rail conducteur.

7. Partie de raccordement selon l'une des revendications précédentes,
**caractérisée en ce que**
- les au moins deux des éléments de raccordement sont disposés sensiblement à la même position le long de l'axe longitudinal d'au moins l'un des au moins deux rails conducteurs et/ou
- au moins l'un des éléments de raccordement est disposé sensiblement sur l'axe central de la section d'extrémité du rail conducteur respectif ou
- **en ce qu'**au moins l'un des éléments de raccordement est disposé de manière sensiblement excentrée par rapport à l'axe central de la section d'extrémité du rail conducteur respectif.

8. Partie de raccordement selon l'une des revendications précédentes,
**caractérisée en ce que**
- l'élément de raccordement est formé comme un boulon de raccordement **et/ou en ce que** l'élément de raccordement est formé comme une douille.

9. Partie de raccordement selon l'une des revendications précédentes,
**caractérisée en ce que**
- au moins l'un des éléments de raccordement se rétrécit dans une direction d'extension vers une face frontale de l'élément de raccordement opposée au rail conducteur.

10. Partie de raccordement selon l'une des revendications précédentes,
**caractérisée en ce que**
- au moins l'un des au moins deux éléments de raccordement présente un trou traversant, en particulier dans la direction de la normale à la surface sur au moins des parties du côté large du rail conducteur.

11. Partie de raccordement selon l'une des revendications précédentes,
**caractérisée en ce que**
- au moins une douille de liaison est reliée à au moins l'un des éléments de raccordement, en particulier par adhérence, par complémentarité de forme et/ou par liaison de matière, par exemple au moyen d'une vis, dans laquelle, en particulier, la longueur de l'au moins une douille de liaison correspond sensiblement au décalage en hauteur des sections d'extrémité des au moins deux rails conducteurs et/ou
- **en ce qu'**au moins deux douilles de liaison sont reliées à respectivement un élément de raccordement, en particulier par adhérence, par complémentarité de forme et/ou par liaison de matière, par exemple au moyen d'une vis, dans laquelle, en particulier, la différence de longueur entre les au moins deux douilles de liaison correspond sensiblement au décalage en hauteur des sections d'extrémité des au moins deux rails conducteurs.

12. Partie de raccordement selon l'une des revendications précédentes,
**caractérisée en ce que**
- l'au moins un joint d'étanchéité entoure les au moins deux rails conducteurs conjointement et/ou individuellement, de préférence
- au moins l'un de l'au moins un joint d'étanchéité est moulé en silicone, en caoutchouc et/ou en matière plastique, **en particulier en ce que** le boîtier et le joint d'étanchéité sont moulés par injection et/ou coulés ensemble, en particulier dans un procédé de moulage par injection à deux composants et/ou de préférence
- au moins l'un de l'au moins un joint d'étanchéité présente au moins deux, de préférence trois nervures ou plus.

13. Partie de raccordement selon l'une des revendications précédentes,
**caractérisée en ce que**
- le boîtier entoure au moins l'un des au moins deux rails conducteurs avec au moins une ouverture pour rail, dans laquelle l'ouverture pour rail est de préférence adaptée en section transversale au rail conducteur, dans laquelle le boîtier comprend en particulier au moins deux pièces partielles qui forment ensemble au moins une ouverture pour rail adaptée en section transversale à au moins l'un des rails conducteurs,
- au moins l'une des au moins deux pièces partielles peut être enfichée sur au moins l'un des au moins deux rails conducteurs sensiblement perpendiculairement à l'axe longitudinal des au moins deux rails conducteurs et/ou sensiblement parallèlement au côté large d'au moins l'un des rails conducteurs, en particulier en partant du côté étroit d'au moins l'un des rails conducteurs et de manière particulièrement préférée
- au moins l'une des au moins deux pièces partielles présente une saillie d'enfichage et/ou au moins l'une des au moins deux pièces partielles présente un logement d'enfichage, dans laquelle, en particulier, la saillie d'enfichage peut être introduite dans le logement d'enfichage, en particulier peut être enfichée sensiblement perpendiculairement à l'axe longitudinal d'au moins une partie d'au moins l'un des au moins deux rails conducteurs, et/ou
- **en ce qu'**au moins un moyen de fixation sont disposés sur au moins l'une des au moins deux pièces partielles, lequel relie les au moins deux pièces partielles entre elles, en particulier un moyen de fixation par force et/ou par complémentarité de forme, en particulier au moins une vis et/ou au moins un filetage.

14. Fiche comportant
- un boîtier de fiche,
- une partie de raccordement selon l'une des revendications précédentes, dans laquelle les au moins deux rails conducteurs sont guidés avec respectivement une section d'extrémité dans le boîtier de fiche et le boîtier de la partie de raccordement est en contact avec le boîtier de fiche dans une zone entourant les rails conducteurs, de préférence indirectement par l'intermédiaire d'un joint d'étanchéité qui est disposé de préférence par ajustement serré entre le boîtier de la partie de raccordement et le boîtier de fiche, et de préférence - au moins un moyen de fixation est disposé sur la partie de raccordement, en particulier sur le boîtier de la partie de raccordement, et/ou sur la fiche, en particulier sur le boîtier de fiche, en particulier un moyen de fixation par force et/ou par complémentarité de forme, en particulier au moins une vis et/ou au moins un filetage.

15. Système comportant une partie de raccordement selon les revendications 1 à 13 et une fiche selon la revendication 14.
